# EUROPÄISCHE PATENTANMELDUNG

(11) **EP 4 847 461 A1**
(43) Veröffentlichungstag der Anmeldung: **02.12.2026**
(21) Anmeldenummer: 25179608.2
(22) Anmeldetag: 28.05.2025
(51) Int. Cl.: C03C 3/089, C03C 3/091, C03C 15/00, C03C 23/00, H01L 21/48

(54) **VERFAHREN ZUR STRUKTURIERUNG EINES ELEMENTS AUS GLASBASIERTEM MATERIAL MIT LASERSTRAHLUNG SOWIE ELEMENT AUS GLASBASIERTEM MATERIAL MIT EINER VIELZAHL VON HOCHGENAUEN DURCHGANGSKANÄLEN UND DESSEN VERWENDUNG**

(71) Anmelder: SCHOTT AG, 55122 Mainz (DE)
(72) Erfinder: WAGNER, Fabian, 55122 Mainz (DE); WALTER, Lukas, 55122 Mainz (DE); KORCZYNSKI, Martin, 55122 Mainz (DE)
(74) Vertreter: Schott Corporate IP

(57) **Zusammenfassung**

Die Erfindung betrifft ein Verfahren zum Einfügen einer Vielzahl von filamentförmigen Schädigungen (2) in ein Element (1) aus glasbasiertem Material, bei dem ein durch ein optisches System (3) fokussierter Laserstrahl (4) eines gepulsten Lasers (5) auf das Element (1) gerichtet wird, wobei das Element (1) transparent für die Wellenlänge λ des Lasers (5) ist. Dabei wird ein ultrakurzer Einzelpuls des Lasers (5) auf das Element (1) gerichtet. Der Einzelpuls erzeugt jeweils eine filamentförmige Schädigung (2), die nachfolgend zu Durchgangskanälen (20) aufgeätzt werden kann.

Die Erfindung betrifft ebenso ein Element (1) aus glasbasiertem Material beinhaltend eine Vielzahl von Durchgangskanälen (20), wobei mindestens eine Testmenge von 1000 Durchgangskanälen Qualitätsmerkmale bzgl. Durchmesserdifferenz Diff_{D} und/oder Durchmesservarianz (Var_{D)} und/oder Varianz der Rundheit (Var_{R}) erfüllt.

## Beschreibung

Die Erfindung betrifft allgemein ein Verfahren zum Strukturieren von Elementen aus glasbasierten Material mittels gepulster Strahlung von Ultrakurzpulslasern sowie Elemente mit einer Vielzahl von hochgenauen, insbesondere geometrisch hochgenauen, Durchganskanälen. Ebenso betrifft die Erfindung die Verwendung der vorgenannten Elemente.

Die Strukturierung von Elementen aus glasbasierten Materialien ist in vielen Anwendungsbereichen von großem Interesse, insbesondere für Anwendungen im HalbleiterBereich, in welchem solche Elemente beispielsweise als Interposer eingesetzt werden. Solche weisen üblicherweise metallisierte Durchgangskanäle auf, die mit Halbleiter-Bauteilen auf deren Oberfläche verbunden werden. Die Durchgangskanäle sind entsprechend in einer geeigneten Matrix angeordnet, die beim Erzeugen der Durchgangskanäle genau eingehalten werden muss. Ebenso bestehen erhebliche Qualitätsanforderungen an die Durchgangskanäle, da deren elektrische Eigenschaften die elektrischen Eigenschaften des Gesamtbauteils beeinträchtigen können und/oder die Verbindbarkeit mit den vorgenannten Halbleiter-Bauteilen.

Besondere Qualitätsaspekte der Durchgangskanäle betreffen insbesondere deren Genauigkeit. Darunter fällt beispielsweise die Übereinstimmung der Durchmesser der Durchgangskanäle auf der Ober- und der Unterseite des Elements. Der vorgegebene Solldurchmesser soll üblicherweise auf der Oberseite und auf der Unterseite des Elements möglichst genau eingehalten werden und insbesondere sollen die Durchmesser der Durchganskanäle auf der Ober- und Unterseite oftmals identisch sein. Gleiche Anforderungen gelten oftmals auch für die Rundheit der Durchgangskanäle.

Zur Erzeugung der Durchganskanäle kann insbesondere die Laserstrukturierung mit Ultrakurzpulslasern eingesetzt werden. Die US 20150166395 A1 beschreibt das Einfügen von laserinduzierten Schädigungen in ein Glasmaterial mittels Ultrakurzpulslasern. Um ausreichend Energie für die Schädigung in dem Glasmaterial zu deponieren, verwendet diese Schrift die Anwendung von Burst-Paketen von Laserpulsen mit 2 oder mehr kurz aufeinander folgenden Pulsen. Die Einzelpulse in dem Burstpaket weisen Pulsdauern von 1 ps bis 100 ps auf. Die erzeugten Schädigungen werden darauf folgend zu Durchgangskanälen aufgeätzt.

Die WO2018049044 A1 beschreibt die Morphologie von mit Ultrakurzpulslasern erzeugten Durchgangskanälen in Glasmaterialien. Darin werden ebenfalls Burstpakete einer Mehrzahl von 10 ps kurzen Laserpulsen als vorteilhaft beschrieben.

Bei der Anwendung der beschriebenen Prozesse hat sich allerdings herausgestellt, dass bei der Bearbeitung von Elementen aus glasbasierten Materialien kein ausreichend stabiles Prozessfenster erreicht werden kann, welches einen rationellen Herstellungsprozess ermöglicht. Oftmals wird keine Durchgängigkeit aller Durchgangskanäle erzielt, d.h. eine signifikante Anzahl von Durchgangskanälen sind nach der Laserbearbeitung und/oder dem folgenden Ätzprozess noch verschlossen. Erfolgt dann eine Metallisierung, ist der Durchgangskanal nicht durchgehend elektrisch leitfähig und beispielsweise der Interposer ist in diesem Bereich unbrauchbar. Ebenso wurden große Variationen in den Durchmessern und/oder der Rundheit der Durchgangskanäle festgestellt, was ebenso die Weiterverarbeitbarkeit eines solchen Elements und/oder die Zuverlässigkeit des Endprodukts negativ beeinflusst.

Daher ist es eine Aufgabe der Erfindung, ein Verfahren anzugeben, dass zuverlässig das Einfügen von Durchgangskanälen in Elemente aus glasbasierten Materialien erlaubt und diese Durchgangskanäle die vorgenannten Genauigkeits- und/oder Qualitätsanforderungen erfüllen. Eine weitere Aufgabe ist die Bereitstellung eines Elements aus glasbasiertem Material mit einer Vielzahl von Durchgangskanälen, welches diese Anforderungen erfüllt.

Die Aufgabe wird gelöst durch das Verfahren und das Element entsprechend den unabhängigen Ansprüchen. Bevorzugte Ausführungsformen ergeben sich aus den davon abhängigen Ansprüchen.

Erfindungsgemäß ist ein Verfahren zum Einfügen einer Vielzahl von filamentförmigen Schädigungen in ein Element aus glasbasiertem Material, bei dem ein durch ein optisches System fokussierter Laserstrahl eines gepulsten Lasers mit einer Wellenlänge λ zum Bearbeiten auf das Element gerichtet wird, wobei das Element transparent für die Wellenlänge λ des Lasers ist und wobei ein Einzelpuls des Lasers auf das Element gerichtet wird. Der Einzelpuls weist vorteilhaft eine Pulsdauer Tp von 0,3 ps bis <5 ps auf. Besonders vorteilhaft sind Pulsdauern von 0,5 ps bis 4 ps, ganz besonders vorteilhaft von 0,8 ps bis 3 ps oder von 0,9 ps bis 1,1 ps. Dieser Einzelpuls erzeugt im Werkstück eine filamentförmige Schädigung. Der fokussierte Laserstrahl wird auf verschiedene Stellen des Elements gerichtet, um dort die filamentförmigen Schädigungen zu erzeugen.

Glasbasierte Materialien sind im Sinne der Erfindung alle Materialien, die zumindest in Bereichen ein glasartiges Netzwerk aufweisen und/oder aus einem Material aus Glas hervorgehen. Glasbasierte Materialien sind insbesondere Gläser als solche, aber auch Glaskeramiken, welche durch zumindest teilweise Kristallisation von Elementen aus Glasmaterial gewonnen werden. Ein Element aus glasbasiertem Material enthält im Sinne dieser Beschreibung zumindest in dem Bereich, in dem eine filamentförmige Schädigung vorhanden ist, ein glasbasiertes Material.

Eine filamentförmige Schädigungen im Sinne der Erfindung ist im Allgemeinen jegliche Form von Materialmodifikation und/oder Materialentfernung, die durch Wechselwirkung des ultrakurzen Laserpulses mit dem Element entsteht. Dies kann Brechungsindexänderungen umfassen, Materialverfärbungen, Schwächen der Materialstruktur insbesondere durch Risse, lokales Aufschmelzen, Ablatieren, Einbringen von Hohlkanälen und/oder Sacklöchern usw.. Als Filament und/oder filamentförmig wird weitestgehend eine langgestreckte, fadenförmige Struktur verstanden, deren Durchmesser bedeutend geringer ist als deren Länge. Insbesondere vorteilhaft ist das Verfahren derart gestaltet, dass hohlkanalförmige Filamente als Initialschädigung in das Element eingebracht werden. Ein solches hohlkanalförmiges Filament zeichnet sich durch den Hohlraum entlang der Filamentachse aus. Ein solcher Hohlkanal geht über eine bloße Materialschädigung und/oder Brechungsindexänderung hinaus und kann das Aufweiten solcher Schädigung durch folgende Ätzverfahren erleichtern.

Die filamentförmige Schädigung entsteht in dem Element durch Wechselwirkung der ultrakurzen Laserstrahlung mit dem glasbasierten Material. Das glasbasierte Material ist im Wesentlichen transparent für die Laserwellenlänge λ. Darunter wird verstanden, dass die Transmission des Elements an dieser Stelle größer als 50% oder größer als 85%, vorteilhaft größer als 90%, besonders vorteilhaft größer als 95% bei der Wellenlänge λ ist. Wird ein ultrakurzer Puls eines solchen Laserstrahl in das glasbasierte Material fokussiert, wird in der Literatur von zwei prinzipiellen Mechanismen ausgegangen, welche die Wechselwirkung des ultrakurzen Laserpulses mit dem glasbasierten Material beschreiben.

Bei dem einen Mechanismus wirken zwei nichtlinearer Effekte zusammen, die Selbstfokussierung des Pulses durch den optischen Kerr-Effekt und seine Defokussierung durch das Plasma, das der Laser im Material erzeugt. Dabei wird davon ausgegangen, dass die Selbstfokussierung über eine Fokuslänge von etwa 500 bis 1000 µm aufrechterhalten wird und dann räumlich dispergiert, wenn die Pulsenergie nicht ausreicht, um wieder selbst zu Fokussieren und erneut einen Plasmakanal zu erzeugen.

Der zweite Mechanismus ist die induzierte Absorption im Medium. Dabei wird durch den fokussierten ultrakurzen Laserstrahl auf einem sehr kleinen Raum so viel Energie in das glasbasierte Material geleitet, dass es zu einer Mehrphotonenabsorption kommt, welche zu einer starken Absorption der Laserstrahlung führt. Als Erklärung wird üblicherweise angegeben, dass die initiale Phase des ultrakurzen Laserpulses freie Ladungsträge erzeugt, was zu einer starken Absorption des dadurch erzeugten Plasmas führt. Dies führt wiederum zu einer weiteren Aufheizung und Ionisierung. Im Technologiefeld der Glasbearbeitung wird dieser Effekt oft kurz als induzierte Absorption bezeichnet.

Mit beiden Effekten können filamentförmige Schädigungen in glasbasierten Materialien erzeugt werden. Im Sinne der Erfindung können beide oder auch Mischformen von beiden vorkommen und/oder angewendet werden.

Im Sinne der Erfindung ist es wesentlich, dass ein einzelner Puls, auch Einzelpuls genannt, zur Erzeugung einer filamentförmigen Schädigung an dem entsprechenden Ort im glasbasierten Material eingesetzt wird. Ein Einzelpuls unterscheidet sich von einem Burst von Pulsen, der in der Praxis üblicherweise für die Erzeugung einer filamentförmigen Schädigung eingesetzt wird, wobei eine Mehrzahl von Einzelpulsen in einem Burstpaket das Filament erzeugen.

Der erfindungsgemäße Einzelpuls hat vorteilhaft eine Pulsdauer Tp von 0,3 ps bis <5 ps. Wie allgemein bekannt wird die Pulsdauer über deren Halbwertsbreite gemessen, auch bezeichnet als "full width at half maximum (FWHM) of he optical power versus the time".

Die Erfinder haben erkannt, dass vollkommen überraschend durch den Einsatz eines solchen ultrakurzen Einzelpulses die Zuverlässigkeit und/oder Stabilität des Prozesses der Filamenterzeugung zunimmt. In Vergleichen zu dem Einsatz eines Bursts hat sich überraschenderweise gezeigt, dass die in Folgeprozessen erzeugten Durchgangskanäle sehr viel zuverlässiger durchgängig sind, weniger Abweichungen der Kanaldurchmesser aufweisen und auch sehr viel weniger Abweichungen in der Rundheit der Durchgangskanäle auftreten. Ebenso kann die Lage von Einschnürungen bei X-förmigen Durchgangskanälen zuverlässig stabil gehalten werden. Auf die Folgeprozesse und die Bedeutung dieser Begriffe wird später im Detail eingegangen.

Durch die Anwendung des Einzelpulses, insbesondere mit der genannten Pulsdauer Tp, scheint eine filamentförmige Schädigung zu entstehen, die nicht mit einer solchen Vielzahl, Stärke oder Länge von Mikrorissen umgeben ist, dass das glasbasierte Material in den Folgeprozessen sozusagen ausreißt. Es wird vermutet, dass die in der Anwendung von Bursts entstehenden Mikrorisse zu unkontrolliert insbesondere bzgl. ihrer Stärke und/oder Länge sind, so dass der aus der filamentförmigen Schädigung durch Folgeprozesse erzeugte Durchgangskanal von seiner Sollstruktur abweichen kann, beispielsweise in seiner Richtung, seiner Rundheit und/oder der Einhaltung des Durchmessers. Die erfindungsgemäße Anwendung des Einzelpulses ermöglicht dahingegen die Einhaltung der Sollstruktur.

Dabei darf nicht außer Acht gelassen werden, dass bei dieser Betrachtung statistische Effekte eine große Rolle spielen. In der Anwendung sollen Elemente aus glasbasierten Materialien erzeugt werden, die viele tausend bis zu einige millionen filamentförmige Schädigungen und daraus hervorgehende Durchgangskanäle beinhalten. Ein stabiler und/oder zuverlässiger Prozess liegt vor, wenn in diesem Maßstab die Sollwerte eingehalten werden. Aufgrund des Anwendungsgebiets sind dabei selbst sehr kleine Abweichungen unerwünscht.

Um die filamentförmige Schädigung an dem gewünschten Ort zu erzeugen, wird der Laserstrahl durch ein optisches System auf das Element gerichtet. Besonders vorteilhaft sind optische Systeme, die eine Fokuslinie im Element erzeugen. Dies kann die Strahltaille eines Gauss-Strahls sein, welche insbesondere durch sphärische Aberration und/oder durch chromatische Aberration einer Fokussierlinse verlängert sein kann. Alternativ kann das optische System vorteilhaft einen Bessel-Strahl erzeugen. Dazu kann besonders vorteilhaft ein asphärisches optisches Element in dem optischen System vorhanden sein, beispielsweise ein Axicon, dessen Apex insbesondere vorteilhaft in Richtung des Elements ausgerichtet ist. Mit den genannten optischen Systemen kann eine langgestrecke Fokuslinie, auch elongierte Fokuslinie genannt, in dem glasbasierten Material erzeugt werden.

Insbesondere vorteilhaft ist eine Ausführungsform des Verfahrens, wobei Laser und/oder optisches System und/oder das Element aus glasbasiertem Material relativ zueinander bewegt werden, wobei an den verschiedenen Stellen des Werkstücks weitere filamentförmige Schädigungen, insbesondere mit den vorgenannten Parametern, in das Element eingebracht werden.

Dies bedeutet im Wesentlichen, dass durch die Relativbewegung von Laser und/oder optischem System zu dem glasbasiertem Material der Ort eingestellt wird, an dem die jeweilige filamentförmige Schädigung in dem Element erzeugt wird. In einer Ausführungsform sind die Positionen von Laser und optischem System gegeneinander fixiert, bis auf ggfls. eine Fokuslagenverstellung, und das Element wird gegenüber diesem Ensemble verfahren. Dazu kann ein xy-Tisch oder jede andere geeignete Verfahreinheit eingesetzt werden. Dabei handelt es sich in der industriellen Umsetzung meistens um computergesteuerte Systeme, welche Sollort, Verfahrstrecken und -geschwindigkeit, Laserpulsauslösung und ggfls. weitere Prozessparameter steuern. Ebenfalls möglich ist es, dass gemeinsam mit der Verfahreinrichtung des Elements das optische System, insbesondere Elemente desselben, und/oder der Laser ebenfalls verfahren werden.

Als besonders vorteilhaft hat sich ein vorgenanntes Verfahren erwiesen, wobei der Einzelpuls eine Einzelpulsenergie Ep von 200 bis µJ bis 800 µJ aufweist, vorteilhaft von 300 µJ bis 700 µJ oder von 300 µJ bis 600 µJ, besonders vorteilhaft von 320 µJ bis 500 µJ. Die Einzelpulsenergie wird nach dem Durchlaufen des Laserstrahls durch das optische System gemessen, also zwischen dem optischen System und der nächstliegenden Oberfläche des Elements aus glasbasiertem Material.

Es hat sich herausgestellt, dass in diesem Energiebereichen insbesondere stabile Prozessfenster zu erreichen sind, und zwar unabhängig von der Zusammensetzung und/oder der spezifischen thermischen Dehnung des zu bearbeitenden glasbasierten Materials.

Für das hierin beschriebene Verfahren können optische Systeme angewendet werden, welche einen Gauss-Strahl auf das Element aus glasbasiertem Material fokussieren und dadurch insbesondere einen elongierten Gauss-Strahl erzeugen. Ebenso möglich ist die Verwendung eines optischen Systems, welches einen Bessel-Strahl auf das Element aus glasbasiertem Material fokussiert. Die optischen Aufbauten zum Erzeugen eines Gauss-Strahls und/oder eines Bessel-Strahls sind weithin bekannt und werden daher nicht weiter im Detail erläutert. In beiden Fällen werden langgezogene, linienförmige Fokuslinien erzeugt, welche die filamentförmige Schädigung im Element aus glasbasiertem Material durch induzierte Absorption erzeugen.

Als Beispiel für optische Systeme, die Bessel-Strahlen erzeugen, sei die WO 2014079570 A1 genannt, bei der ein Axicon, dessen Apex in Richtung des zu bearbeitenden Elements ausgerichtet ist, eingesetzt wird. Die WO 2019158488 A1 beinhaltet zum Beispiel auch ein plankonvexes Axicon, welches einfacher zu justieren ist als ein Axicon mit einem ausgeprägten Apex.

Wie zuvor beschrieben können Gauss-Strahlen durch optische Systeme beinhaltend sphärische Linsen erzeugt werden. Solche Systeme sind beispielsweise in der WO 2018210746 A1 beschrieben, in welcher die chromatische Aberration zur Fokusverlängerung beiträgt.

In dem hierin relevanten Technologiefeld hat es sich als Problem herausgestellt, dass sich unterschiedliche glasbasierte Materialien unterschiedlich in der Laserbearbeitung verhielten. Das unterschiedliche Verhalten wurde oftmals durch die unterschiedliche thermische Dehnung (CTE) der Materialien erklärt.

Unter CTE (coefficient of thermal expansion) wird, wie allgemein bekannt, der lineare thermische Ausdehnungskoeffizient im Temperaturbereich von 20°C bis 300°C verstanden.

Die Erfindung stellt dahingehend ein universelles Prozessfenster für glasbasierte zur Verfügung, das für einen sehr weiten Bereich von CTEs und/oder Glaszusammensetzungen anwendbar ist. Vorteilhaft weist ein glasbasiertes Material zur Anwendung in dem beschriebenen Verfahren einen CTE von 2,5·10⁻⁶ K⁻¹ bis 10,0·10⁻⁶ K⁻¹ auf, vorteilhaft von 2,5·10⁻⁶ K⁻¹ bis 5,5·10⁻⁶ K⁻¹ oder von >5,5·10⁻⁶ K⁻¹ bis 8,0·10⁻⁶ K⁻¹.

Ebenso möglich ist natürlich die Anwendung des Verfahrens auf glasbasierte Materialien, insbesondere Glaskeramiken, die einen deutlich geringeren CTE aufweisen, beispielsweise einen Solchen im Bereich 0 ± 0,5 K⁻¹.

In der industriellen Anwendung können Gläser des Typs 1, welche einen CTE von >5,5·10⁻⁶ K⁻¹ bis 10·10⁻⁶ K⁻¹ aufweisen, insbesondere von >5,5·10⁻⁶ K⁻¹ bis 8,0·10⁻⁶ K⁻¹, von Gläsern des Typs 2 differenziert werden, welche einen CTE von 2,5·10⁻⁶ K⁻¹ bis 5,5·10⁻⁶ K⁻¹ aufweisen. Mit den hierin genannten Parametern lassen sich insbesondere vorteilhaft stabile Prozesse für beide Glastypen erreichen. Dies bedeutet, dass die Herstellungsprozesse mit einem Parametersatz für die Laserbearbeitung eingestellt werden können, und dann glasbasierte Materialien, insbesondere Gläser, in dem genannten CTE-Bereich mit diesem Parametersatz prozessiert werden können.

Erstaunlicherweise stellen die in dieser Erfindung genannten Parameter und/oder deren Kombination ein sozusagen universelles Parameterfenster zur Verfügung, mit welchem alle glasbasierten Materialien, insbes. diejenigen des Typs 1 und des Typs 2, bearbeitet werden können. Insbesondere in einem stabilen Prozessfenster. Ein Solches zeichnet sich hinsichtlich der Einhaltung der Solldurchmesser und der Rundheit der Durchgangskanäle aus, und ebenfalls der Lage der Einschnürung bei X-förmigen Durchgangskanälen.

Diese Erkenntnisse widersprechen der Erwartung insbesondere insofern, dass zuvor angenommen wurde, dass glasbasierte Materialien des mit einem vergleichsweise hohen CTE empfindlicher auf den durch die induzierte Absorption der Energie des Laserstrahls im Fokusbereich transienten Wärmeeintrag reagieren als Solche mit einem vergleichsweise geringem CTE. Wird die Laserenergie reduziert, um das empfindlichere Material mit dem hohen CTE sozusagen zu schonen, sollte davon ausgegangen werden, dass die Energie nicht reicht, um das Material mit dem niedrigeren CTE ausreichend zu schädigen. Und umgekehrt.

Vorteilhaft ist das glasbasierte Material ein Multikomponentenglas ist, enthaltend (in Gew% auf Oxidbasis) SiO₂ + Al₂O₃ im Bereich von 55% bis 85%.

Ein vorteilhaftes Verfahren sieht vor, dass das glasbasierte Material ein Multikomponentenglas ist enthaltend (in Gew% auf Oxidbasis):

| | |
|---|---|
| SiO₂ | 55 - 85, |
| Al₂O₃ | 0 - 20, |
| B₂O₃ | 5 - 30, |
| Alkalien | 0 - 15. |

Als Alkalien wir wie üblich verstanden Na₂O, K₂O und Li₂O, die einzeln oder sämtlichen Kombinationen derselben vorhanden sein können. Die Gehaltsangabe bezieht auf die Summe dieser Komponenten.

Vorteilhafte Zusatzkomponenten, die optional enthalten sein können, sind CaO und/oder ZnO mit folgenden Gehalten (in Gew% auf Oxidbasis): CaO von 0 - 8% und/oder ZnO von 0 - 7%.

Eine weitere vorteilhafte Ausgestaltung des Verfahrens sieht vor, dass das glasbasierte Material ein Multikomponentenglas ist, das einen CTE von 2,5·10⁻⁶ K⁻¹ bis 5,5·10⁻⁶ K⁻¹ aufweist und enthält (in Gew% auf Oxidbasis):

| | |
|---|---|
| SiO₂ | 76 - 84, |
| Al₂O₃ | 0 - 4, |
| B₂O₃ | 8 - 15, |
| Alkalien | 0 - 5,5, |

besonders vorteilhaft mit SiO₂ + Al₂O₃ von 76 bis 85.

Alternativ ist das glasbasierte Material ein Multikomponentenglas mit einem CTE von >5,5·10⁻⁶ K⁻¹ bis 8,0·10⁻⁶ K⁻¹ enthält (in Gew% auf Oxidbasis):

| | |
|---|---|
| SiO₂ | 60 - 73, |
| Al₂O₃ | 0 - 15, |
| B₂O₃ | 6 - 26, |
| Alkalien | 0,5 - 15, |

besonders vorteilhaft mit SiO₂ + Al₂O₃ von 65 bis <76.

Vorteilhaft ist eine Ausgestaltung des Verfahrens, bei dem das Element aus glasbasiertem Material eine Dicke W von 0,3 mm bis 1,5 mm aufweist, insbesondere von 0,5 mm bis 1,2 mm oder von 0,7 mm bis 1,2 mm.

Der Begriff "Dicke" ist synonym mit "Materialstärke" zu versehen. Das glasbasierte Element kann insbesondere und/oder meistens scheibenförmig sein, mit Hauptflächen und sehr viel dünneren Seitenflächen. Die Hauptflächen sind die jeweilige Ober- und Unterseite des Elements. Die Dicke des Elements ist dann der vertikale Abstand der Hauptflächen.

Vorteilhaft ist ebenso eine Ausgestaltung des Verfahrens, wobei mehr als 1000, insbesondere von 1000 bis 10⁷ filamentförmige Schädigungen in das Element eingebracht werden. Selbstverständlich ist eine noch größere Anzahl von filamentförmigen Schädigungen möglich, insbesondere bei sehr großen Elementen.

Ein besonders vorteilhaftes Verfahren ist ein Solches, wobei die filamentförmigen Schädigungen durch das Einwirken eines Ätzmediums zu Durchgangskanälen aufgeweitet werden. Vorteilhaft umfasst das Ätzmedium H₂SiF₆ oder Mischungen von HF und H₂SO₄ oder HF und/oder HCl oder NaOH und/oder KOH.

Das Ätzen ist ein weiterer Behandlungs- und/oder Verfahrensschritt, welcher der Laserfilamentierung folgt. Dabei wird das Element aus glasbasiertem Material einem Ätzmedium ausgesetzt, welches das Material des Elements abträgt und die filamentförmige Schädigung zu einem Kanal, auch Durchgangskanal genannt, aufweitet, der folglich mit seiner Längsrichtung in Richtung der Längsrichtung der filamentförmigen Schädigung liegt. Insbesondere werden nasschemische Ätzprozesse eingesetzt. Mögliche Ätzprozesse sind bekannt und beispielsweise in der EP 3984970 A1 beschrieben. Daher wird von der Nennung weiterer Details hierin abgesehen.

In einer besonders vorteilhaften Ausgestaltung des Verfahrens weisen der oder die Durchgangskanäle nach dem Ätzen einen Durchmesser von 5 µm bis 200 µm und vorteilhaft 10 µm bis 150 µm auf, gemessen an dem Kanaleingang auf der Ober- oder der Unterseite des Elements. Besonders vorteilhaft sind Durchmesser von 20 µm bis 120 µm und/oder von 40 µm bis 100 µm. Insbesondere weist der arithmetische Mittelwert der Durchmesser die vorgenannten Zahlenwerte auf.

Wie beschrieben beziehen sich die Angaben der Durchmesser auf die jeweiligen Kanaleingänge und -ausgänge auf der Ober- und Unterseite des Elements aus glasbasiertem Material. Abhängig von der Geometrie der Durchgangskanäle können diese durchaus voneinander verschieden sein. Üblicherweise werden zylinderförmige Geometrien angestrebt. Bei Solchen sind die Durchmesser auf der Ober- und Unterseite zumindest weitestgehend gleich. Ebenso möglich ist eine Geometrie, bei denen der Schnitt durch die Durchgangskanalachse und senkrecht durch die Elementoberflächen, im Folgenden Kanalgeometrie genannt, X-förmig ausgebildet ist. Auch in dieser Ausführungsform können die Durchmesser der Kanaleingänge und -ausgänge im Wesentlichen gleich sein. Eine weitere mögliche Kanalgeometrie ist V-förmig, wobei der Kanaldurchmesser auf einer der Hauptflächen des Elements größer ist als auf der anderen. Ein solche V-förmiger Durchgangskanal kann beispielsweise einen Durchmesser von 40 µm auf der Oberseite des Elements aufweisen, und 80 µm auf der Unterseite. Oder umgekehrt.

Die Durchmesser eines Kanaleingangs oder Kanalausgangs werden im Sinne dieser Beschreibung durch Bilderkennung unter Nutzung von Analysemikroskopen bestimmt. Der Durchmesser eines Kanaleingangs oder Kanalausgangs wird durch computergestützte Auswertung des Bildes einer Testmenge von Kanaleingängen und -ausgängen berechnet. Dazu werden Testelemente mit einer Vielzahl von Durchgangskanälen hergestellt, insbesondere mit mehr als 1000 Durchgangskanälen, und die Testmenge von 1000 Durchgangskanälen wird untersucht. Insbesondere sollen die Durchgangskanäle der Testmenge nebeneinander liegen. Diese Messmethode ist weniger fehlerverzeihend als eine Methode, bei welcher eine statistisch verteilte Menge von Durchgangskanälen untersucht wird. Die Fläche der jeweiligen Kanaleingänge und Kanalausgänge wird mittels Bilderkennung und -auswertung bestimmt und unter Annahme eines idealen Kreises der jeweilige Durchmesser berechnet.

Wie beschrieben kann durch die Erfindung ein stabiles Prozessfenster erreicht werden. Ein stabiles Prozessfenster wird insbesondere hinsichtlich der Fokuslage des Laserfokus erreicht, weil diese Fokuslage unter Produktionsbedingungen im industriellen Umfeld schwerlich absolut stabil gehalten werden kann. Als Fokuslage ist insbesondere die vertikale Position des Laserfokus in Bezug auf die Oberseite des Elements zu verstehen, wobei die Oberseite die dem Laser zugewandte Seite ist. Um ein stabiles Prozessfenster zu qualifizieren, werden also die Abweichungen von wesentlichen Parametern und/oder Eigenschaften des bearbeiteten Elements in Abhängigkeit des Fokuslagenbereichs F₀ ± s untersucht, und zwar insbesondere im Bereich von s = ±3 mm um F₀. Im Sinne der vorliegenden Beschreibung sind insbesondere die Varianz der Durchmesser der Durchgangskanäle sowie deren Rundheit und/oder Rundheitsvarianz von Interesse.

Ein besonders vorteilhaftes Verfahren ist ein Solches, wobei ein stabiles Prozessfenster bzgl. des Fokuslagenbereichs F₀ + s des fokussierten Laserstrahls eingestellt wird, in dem die Durchmesservarianz Var_{D} der Durchmesser (D_{O}, D_{U}) der Kanalmündungen der Durchgangskanäle auf der Oberseite O und der Unterseite U des Elements, gemessen wie hierin beschrieben, weniger als 5% und/oder die Durchmesserdifferenz Diff_{D} weniger als 4 µm beträgt. Vorteilhaft beträgt Diff_{D} weniger als 3 µm, besonders vorteilhaft weniger als 2 µm. Var_{D} und/oder Diff_{D} werdeb jeweils bestimmt bei einer Testmenge von 1000 Durchgangskanälen, für jede auftretende Fokuslage F im Fokuslagenbereichs (F₀ + s) des fokussierten Laserstrahls.

Dies bedeutet mit anderen Worten, dass der Laserfokus in einem Bereich ±s mm um die vertikale Ausgangsposition F₀ des Fokus auf das Element gerichtet wird und/oder richtbar ist und dass die Durchmesservarianz Var_{D} der Durchmesser der Kanalmündungen der Durchgangskanäle auf der Oberseite und Unterseite des Elements, gemessen wie hierin beschrieben, weniger als 5% beträgt und/oder die Durchmesserdifferenz Diff_{D} weniger als 4 µm, vorteilhaft weniger als weniger als 3 µm, besonders vorteilhaft weniger als 2 µm beträgt, jeweils bestimmt bei einer Testmenge von 1000 Durchgangskanälen

Die Fokuslage-Nulllage F₀ ist wie beschrieben die eingestellte Ausgangsosition des Fokus. Dieser kann als die Position der Strahltaille auf der Bildseite des abbildenden optischen Systems. Die reale Fokusposition F ist die um die Strecke s abweichende Fokuslage um F₀. Es gilt somit F = F₀ ± s. F₀ ± s wird auch als Fokuslagenbereich bezeichnet.

Die Kanalmündungen auf der Oberseite O des Elements, das ist die dem Laser zugewandte Seite, sind die Kanaleingänge. Die der Oberseite gegenüberliegende Seite des Elements ist dessen Unterseite U. Die Kanalmündungen auf der Unterseite sind die Kanalausgänge und/oder die Kanaleingänge auf der Unterseite des Elements. Wie beschrieben handelt es sich um die Kanalmündungen nach dem Ätzen.

Die Durchmesservarianz Var_{D} setzt die arithmetischen Mittelwerte, in der folgenden Formel kurz Mittelwert, der Durchmesser D_{O} der Kanaleingänge und D_{U} der Kanalausgänge innerhalb der Testmenge ins Verhältnis. Es gilt: ${Var}_{D} = \left|1-\frac{Mittelwert {D}_{O}}{Mittelwert {D}_{U}}\right|$

Varo wird im Sinne dieser Beschreibung in % angegeben.

Die Durchmesserdifferenz Diff_{D} bezeichnet hierin die Differenz der arithmetischen Mittelwerte der Durchmesser der Kanaleingänge und Kanalausgänge innerhalb der Testmenge: ${Diff}_{D} = Mittelwert {D}_{O} - Mittelwert {D}_{U}$

Wie beschrieben handelt es sich bei Var_{D} und Diff_{D} um statistische Aussagen, die anhand einer Testmenge von Durchgangskanälen bestimmt werden, und zwar bei einer Vielzahl von wie hierin beschrieben hergestellten Elementen, bei denen die Fokuslage um F₀ verschoben wurde. Bei zylindrischen oder X-förmigen Durchgangsöffnungen wird insbesondere vorteilhaft angestrebt, dass der Betrag von Diff_{D} möglichst klein ist, d.h. null oder möglichst nahe an null betragen soll.

Ein weiteres Qualitätskriterium für ein hergestelltes Element und/oder einen Durchgangskanal ist die Rundheit eines Kanaleingangs und/oder -ausgangs. Die Rundheit, hierin abgekürzt als "Ron", wird im Sinne dieser Beschreibung ähnlich wie der Durchmesser durch Bilderkennung unter Nutzung von Analysemikroskopen bestimmt. Für die die Bestimmung der Rundheit gilt folgende Formel: $Rundheit = \frac{4 ⋅ π ⋅ Area}{{Perimeter}^{2}}$

Area steht für die Fläche des jeweiligen Kanaleingangs oder Kanalausgangs und Perimeter für den angefitteten Kreisumfang. In diesem Fit wird um das fotografisch aufgenommene Bild eines Kanaleingangs oder Kanalausgangs ein Kreis so gelegt, dass dieser alle dem Kanaleingang oder Kanalausgang zuzuordnenden Bildpunkte umfasst und dabei einen minimalen Radius aufweist. Die Area wird auf Basis dieser Bildpunkte selbst berechnet. Im Prinzip vergleicht die so bestimmte Rundheit die Fläche des vorhandenen Kanaleingangs oder Kanalausgangs mit der Fläche eines jeweils umhüllenden Kreises.

Ron_{O} ist die Rundheit eines Kanaleingangs auf der Oberseite des Elements, Ron_{U} der die Rundheit eines Kanalausgangs auf der Unterseite des Elements.

Die Rundheit ist für die Interpretation der Messergebnisse allerdings nicht als absoluter Wert heranzuziehen, da der ermittelte Wert von Parametern wie Sensorauflösung und dem Vergrößerungsfaktor des Mikroskops abhängt. Daher wird für die Betrachtung eines stabilen Prozessfensters und/oder der Qualität eines Durchgangskanals das Verhältnis Var_{R} der Rundheit Ron_{O} der Kanaleingänge auf der Oberseite des Elements und Ron_{U} der Kanalausgänge auf der Unterseite des Elements herangezogen, und zwar auf Basis als arithmetischer Mittelwert der Rundheiten aus einer Testmenge: ${Var}_{R} = \left|1-\frac{Mittelwert {Ron}_{O}}{Mittelwert {Ron}_{U}}\right|$

Var_{R} wird im Sinne dieser Beschreibung in % angegeben. Da nur die Größe der Varianz von Bedeutung ist, wird der Betrag der o.g. Berechnung für die Bemessung der Varianz herangezogen. Dies gilt gleichermaßen für Var_{D} und Var_{R}. Auch hier wird ein Wert von null oder möglichst nahe an null angestrebt.

Die Mittelwerte der Rundheit Ron wird bestimmt bei einer Testmenge von 1000 Durchgangskanälen. Diese liegen insbesondere nebeneinander. Dies bedeutet mit anderen Worten, es wird ein Testelement mit einer Vielzahl von Durchgangskanälen hergestellt, mehr als 1000, und die Testmenge der Durchgangskanäle wird untersucht.

Ein weiteres vorteilhaftes Verfahren ist ein Solches, wobei ein stabiles Prozessfenster bzgl. der Fokuslage wie des Linienfokus wie hierin beschrieben eingestellt wird, das dadurch gekennzeichnet ist, dass die Rundheitsvarianz Var_{R} der Rundheit der Kanalmündungen der Durchgangskanäle auf der Oberseite und der Unterseite des Elements, gemessen wie hierin beschrieben, weniger er als 5% beträgt, bevorzugt weniger als 3%, besonders bevorzugt weniger als 2%, bestimmt bei einer Testmenge von 1000 Durchgangskanälen.

Vorteilhaft wird in dem beschriebenen Verfahren der Fokuslagenbereich (F₀ ± s) eingestellt, wobei (F₀ ± s) einen Bereich von > 0,5 mm abdeckt, insbesondere von >0,5 mm bis 3 mm oder von >0,5 mm von bis 2 mm oder von >0,5 mm bis 1,3 mm. Dies bedeutet insbesondere, dass ein stabiles Prozessfenster in einem breiten Fokuslagenbereich (F₀ ± s) erreichbar ist.

Besonders vorteilhaft ist ein Verfahren, wobei der oder die Durchgangskanäle einen Öffnungswinkel von 0° bis 3° aufweisen, gemessen von der Längsachse des jeweiligen Durchgangskanals. Besonders vorteilhaft sind die Durchgangskanäle zylinderförmig oder V-förmig oder X-förmig.

Der Öffnungswinkel ist der doppelte Winkel 2·α zwischen der Kanalwand des Durchgangskanal und dessen Längsachse. Zur Bestimmung wird ein wie beschrieben hergestelltes Element quer zu dessen Ober- und Unterseite getrennt, und zwar so, dass die Schnittfläche durch die Längsachse der entsprechenden Durchgangskanäle verläuft. Mikroskopisch können dann Kanalwände und deren Öffnungswinkel bestimmt werden. Beträgt der Öffnungswinkel im Wesentlichen 0°, ist die Geometrie des Durchgangskanals zylinderförmig. Liegt ein genannter Öffnungswinkel vor, dann kann der Durchgangskanal V-förmig oder X-förmig sein. Besonders vorteilhaft sind zylinderförmige oder V-förmige Durchgangskanäle.

Eine weitere vorteilhafte Ausgestaltung des Verfahrens sieht vor, dass an der inneren Wandung des Durchgangskanals kalottenförmige Einprägungen erzeugt werden, die in Richtung der Umfangsfläche der inneren Durchgangskanalwandung ausgedehnter sind als in Richtung der Längsachse des Durchgangskanals. Insbesondere vorteilhaft liegt ein Aspektratio von mehr als 3:1 vor.

Die Kombination der Laserfilamentierung mit dem Einzelpuls und dem darauf folgenden Ätzprozess führt entsprechend vorteilhaft zu einer Mikrostrukturierung der inneren Wandung der Durchgangskanäle, welche in Form von kalottenförmigen Einprägungen vorliegt. Es wird vermutet, dass diese, genauer gesagt eine Initialform, beim Einfügen der filamentförmigen Einrpägungen in die Wand des Elements eingeprägt werden. Der nachfolgende Ätzprozess weitet die filamentförmigen Schädigungen zu Durchgangskanälen auf, wobei die prinzipielle Struktur der kalottenförmigen Einprägungen erhalten bleibt, aber aufgeweitet wird. Weil die filamentförmige Schädigung quer zu ihrer Längsachse aufgeweitet wird, nicht aber in Richtung der Längsachse selbst, scheint es eine Verschiebung des Aspektverhältnisses der kalottenförmigen Einprägungen zu kommen, so dass diese in Richtung der Umfangsfläche der inneren Durchgangskanalwandung ausgedehnter sind als in Richtung der Längsachse des Durchgangskanals.

Das Aspektratio der kalottenförmigen Einprägungen kann größer als 3:1 sein, inbesondere vorteilhaft von 3:1 bis etwas 7:1. Unter Aspektarion wird wie üblich das Verhältnis des Werts der maximalen Ausdehnung zum Wert der minimalen Ausdehnung verstanden, hier also die Ausdehung der kalottenfärmigen Einprägung entlang des Radius der inneren Kanalwand im Verhältnis zu deren Ausdehnung parallel zur Kanalachse.

Die kalottenförmigen Einprägungen bewirken mehrere Vorteile. Zunächst einmal stellen die abgerundeten Strukturen eine besonders günstige Form dar, um an der Oberfläche der Kanalwände auftretende Zugspannungen bis zu den tiefsten Punkten der Oberfläche, nämlich den tiefsten Punkten der Kalotten, abzubauen. Damit wird das Risswachstum an möglichen Defekten der Oberfläche wirksam unterdrückt. Die Erhebungen der Kalotten bilden weiterhin sozusagen eine Netzstruktur, welche den Durchganskanal gegenüber mechanischer Belastung stabilisieren kann. Insbes. kann das Element durch diese besondere Struktur gegenüber Verbiegungen mechanisch stabilisiert werden, so dass damit hergestellte Gegenstände eine verbesserte Lebensdauer aufweisen können.

In einer weiteren vorteilhaften Ausgestaltung des Verfahrens werden der oder die Durchgangskanäle in einem folgenden Verfahrensschritt metallisiert.

Die kalottenförmigen Einprägungen können synergistisch mit der Metallisierung zusammenwirken, da sie die Haftung der Metallschichten auf der inneren Kanalwandung verbessern können. Die Metallisierung erzeugt im Allgemeinen eine leitfähige Schicht oder eine komplette Verfüllung der Durchgangskanäle, die somit elektrisch leitfähig gemacht werden. Dadurch, dass das Aspektratio die genannten Werte aufweist, kann eine einfachere Metallisierbarkeit erreicht werden.

Das beschriebene Verfahren ermöglicht die Herstellung eines vorteilhaften Elements aus glasbasiertem Material.

Die Erfindung betrifft ebenso ein Element aus glasbasiertem Material beinhaltend eine Vielzahl von Durchgangskanälen, vorteilhaft mindestens 1000 Durchgangskanäle, besonders vorteilhaft von 1000 bis 10⁷ Durchgangskanälen, wobei mindestens eine Testmenge von 1000 Durchgangskanälen zumindest eines der folgenden Merkmale aufweist:
- Öffnungswinkel 2·α von 0° bis 3° und/oder
- Var_{D} weniger als 5% oder Diff_{D} weniger als 4 µm,
- Var_{R} weniger als 5%.

Besonders vorteilhaft liegen alle der genannten Merkmale gleichzeitig vor. Die genannten Merkmale sind Qualitätsmerkmale und Folge eines stabiles Prozessfensters.

Die anlässlich des Verfahrens beschriebenen voreilhaften oder bevorzugten Bereiche gelten selbstverständlich auch für das Element. Ebenso betreffen im Rahmen der Beschreibung bzgl. dergemachte Aussagen auch das Element.

Besonders vorteilhaft ist ein Element, wobei das glasbasierte Material ein Multikomponentenglas ist, bevorzugt mit einem CTE von 2,5·10⁻⁶ K⁻¹ bis 8·10⁻⁶ K⁻¹, besonders bevorzugt mit einem CTE von 2,5·10⁻⁶ K⁻¹ bis 5,5·10⁻⁶ K⁻¹ oder von
>5,5·10⁻⁶ K⁻¹ bis 8,0·10⁻⁶ K⁻¹.

Insbesondere der niedrigere CTE-Bereich ermöglicht besonders Vorteilhat die Kombination des Elements aus glasbasiertem Material mit Bauteilen basierend auf Silizium und/oder allgemein das Montieren von Halbleiterbauteilen auf dem Element aus glasbasiertem Material.

Insbesondere vorteilhaft ist ein Element, wobei das glasbasierte Material ein Multikomponentenglas ist enthaltend (in Gew% auf Oxidbasis) SiO₂ + Al₂O₃ von 65% bis 85%, bevorzugt von 65% bis <76%.

Wie beschrieben ermöglicht die Anwendung eines Einzelpulses auf Elemente aus glasbasiertem Material mit den genannten Komponenten das stabile Prozessfenster, welches wiederum zu den vorgenannten Qualitätsmerkmalen führt.

Ein weiteres vorteilhaftes Element aus glasbasiertem Material sieht vorteilhaft vor, dass das glasbasierte Material ein Multikomponentenglas ist enthaltend (in Gew% auf Oxidbasis)

| | |
|---|---|
| SiO₂ | 55 - 85, |
| Al₂O₃ | 0 - 20, |
| B₂O₃ | 0 - 30, |
| Alkalien | 0 - 15. |

Besonders vorteilhaft beinhaltet das Multikomponentenglas (in Gew% auf Oxidbasis)

| | |
|---|---|
| SiO₂ | 76 - 84, |
| Al₂O₃ | 0 - 4, |
| B₂O₃ | 8 - 15, |
| Alkalien | 0 - 5,5, |

vorteilhaft mit SiO₂ + Al₂O₃ von 76 bis 85, und weist einen CTE von 2,5·10⁻⁶ K⁻¹ bis 5,5·10⁻⁶ K⁻¹ auf.

Alternativ beinhaltet ein besonders vorteilhaftes Multikomponentenglas (in Gew% auf Oxidbasis)

| | |
|---|---|
| SiO₂ | 60 - 73, |
| Al₂O₃ | 0 - 15, |
| B₂O₃ | 6 - 26, |
| Alkalien | 0,5 - 15, |

vorteilhaft mit SiO₂ + Al₂O₃ von 65 bis <76, und weist einen CTE von >5,5·10⁻⁶ K⁻¹ bis 8,0·10⁻⁶ K⁻¹ auf.

Die genannten Multikomponentengläser sind gut mit Laserbearbeitung zu strukturieren, insbesondere können effektiv filamentförmige Schädigungen wie hierin beschrieben eingebracht werden. Weiterhin reagieren sie gut auf folgende Ätzverfahren, so dass zuverlässig Durchgangskanäle erzeugt werden können. Andererseits ist es ebenso möglich, sie rationell zu metallisieren.

Eine weitere vorteilhafte Ausgestaltung des Elements sieht vor, dass das Element scheibenförmig ist, insbesondere mit einer Dicke W von 0,3 mm bis 1,5 mm, insbesondere von 0,5 mm bis 1,2 mm. Besonders vorteilhaft sind die Durchgangskanäle metallisiert, zumindest eine bestimmte Anzahl oder Mehrzahl von Durchgangskanälen.

Besonders vorteilhaft befinden sich auf zumindest einer Oberfläche des Elements elektrische Leiterbahnen, die mit Durchgangskanälen verbunden sind, insbesondere mit der Metallisierung von Durchgangskanälen.

Eine vorteilhafte Ausgestaltung ist ein Element mit zumindest einem Halbleiterbauteil, das auf einer Oberfläche des Elements angebracht ist, und/oder einem optischen Wellenleiter, der in dem Element eingebracht ist und/oder auf diesem aufgebracht ist.

So können beispielsweise auf einer der Oberflächen des Elements insbesondere elektronische und/oder optoelektronische Bauteile montiert sein, die durch die Durchgangskanäle mit der gegenüberliegenden Seite elektrisch verbunden sind. Entsprechend kann das Element ein Carrier-Element oder ein Interposer sein.

Zusätzlich oder alternativ zu den elektrischen Leitern kann auf dem Element ein optischer Wellenleiter aufgebracht sein oder ein solcher kann in dem Element eingebracht sein.

Dies umfasst, dass ein optischer Wellenleiter beispielsweise in Form einer Lichtleitfaser auf dem Element vorhanden sein kann. Diese kann auf dem Element verlegt und vorteilhaft auf diesem fixiert sein. Ebenso ist es möglich, dass Wellenleiter auf dem Element abgeschieden werden, beispielsweise durch PVD oder andere Beschichtungsverfahren.

Ebenso ist es möglich, optische Wellenleiter in das Element einzubringen. Insbesondere bekannt sind Ionen-Austauschverfahren und/oder laserbasierte Verfahren, bei denen Wellenleiter sozusagen in das Material des Elements eingeschrieben werden. Diese Verfahren bewirken eine Modifikation des Brechungsindex des glasbasierten Materials im Bereich des Wellenleiters, im Allgemeinen eine lokale Erhöhung des Brechungsindex, so dass elektromagnetische Strahlung in diesem Bereich geführt werden kann.

Die Erfindung umfasst auch die Verwendung eines beschriebenen Elements als Interposer und/oder Substrat zur Montage von elektronischen Bauelementen, insbesondere Halbleiterbateile, und/oder als Substrat zum Einbringen oder Montieren von optischen Wellenleitern.

Ein Element im Sinne der Erfindung ermöglicht vorteilhaft die Kombination der elektrischen und optischen und/oder optoelektronischen Funktionen auf einem Element, da diese Anwendungen von den Qualitätsmerkmalen profitieren, die das hierin beschriebene Element zur Verfügung stellt. Damit profitieren auch die genannten vorteilhaften Verwendungen.

Für die Herstellung der hierin beschriebenen Elemente aus glasbasiertem Material und zum Erhalt der Messwerte wurde ein Neodym-dotierter Yttrium-Aluminium-Granat basierte Ultrakurzpulslaser mit einer Wellenlänge von 1064 Nanometern und variabler Pulsdauer von 0,3 ps bis >7 ps auf eine Vielzahl von Elementen gerichtet und jeweils mehr als 1000 filamentförmige Schädigungen erzeugt und daraufhin in Ätzbädern zu Durchgangsöffnungen erweitert, die für diese Testzwecke einen Durchmesser von 30 µm bis 120 µm aufwiesen.

Als Ätzmedium wird eine Ätzlösung besonders bevorzugt. Das Ätzen wird gemäß einer vorteilhaften Ausführungsform also nasschemisch durchgeführt. Dies ist günstig, um während des Ätzens Glasbestandteile von der Oberfläche zu entfernen. Als Ätzlösungen können sowohl saure, als auch alkalische Lösungen verwendet werden. Als saure Ätzmedien sind wie zuvor beschrieben insbesondere H₂SiF₆ oder Mischungen von HF und H₂SO₄ oder HF und/oder HCl geeignet. Für basische Ätzmedien kommen bevorzugt KOH- oder NaOH-Laugen in Betracht. Mit sauren Ätzlösungen lassen sich typischerweise größere Abtragsraten erzielen. Basische Lösungen sind aber vorteilhaft, zumal ohnehin nur ein langsamer Abtrag angestrebt wird.

Das Ätzen wird insbesondere in einem Temperaturbereich von 40 °C bis 150 °C, vorteilhaft von 50° bis 120°, durchgeführt.

Die Erfindung sieht den Einsatz eines Einzelpulses zum Erzeugen der filamentförmigen Schädigungen vor. Um die Wirkung zu untersuchen, wurden im Vergleich Elemente untersucht, die im Burst-Betriebsmodus des Lasers erzeugt wurden.

Ebenso hergestellt wurden Elemente unter Einwirkung verschiedener Pulsenergien, hierin insbesondere im Bereich von 100 µJ bis 1000 µJ.

Die Laserquelle erzeugt beispielsweise einen Rohstrahl mit einem (1/e²)-Durchmesser von 12 mm. Der Rohstrahl wird durch ein optisches System so in dem Element fokussiert, dass durch induzierte Absorption filamentförmige Schädigungen entstehen. Für die hierin beschriebenen Versuche wurden optische Systeme eingesetzt, welche eine langgestreckte Fokuslinie im Element erzeugen. Dies waren einerseits optische Systeme, welche einen Bessel-Strahl durch den Einsatz asphärischer Elemente erzeugen, oder einen Gauss-Strahl, der insbesondere durch die chromatische und/oder sphärische Aberration von Linsen verlängert wird.

Die Erfindung soll nachfolgend anhand der Figuren und ohne Beschränkung hierauf eingehender beschrieben werden. Gleiche Bezugszeichen bezeichnen dabei gleiche oder ähnliche Elemente. Die Figuren und die zugehörige Beschreibung repräsentieren ebenso Ausführungsbeispiele.

Es zeigen:
- Fig. 1:: Das Schema einer Laserbearbeitungseinrichtung
- Fig. 2:: Das Schema eines optischen Systems
- Fig. 3:: Das Schema eines weiteren optischen Systems
- Fig. 4a:: Schematische Fokuslagen im Element
- Fig. 4b:: Schematische filamentförmige Schädigungen im Element
- Fig. 5:: Prinzip einer Einzelpulssequenz
- Fig. 6:: Fotografische Aufnahme eines erzeugten Elements in der Aufsicht
- Fig. 7a:: Schematischer Querschnitt eines Elements
- Fig. 7b:: Schematischer Querschnitt eines weiteren Elements
- Fig. 7c:: Schematischer Querschnitt eines weiteren Elements
- Fig. 7d:: Schematischer Querschnitt eines weiteren Elements
- Fig. 8:: Schematische Aufsicht auf ein Element
- Fig. 9:: Abhängigkeit der Kanaldurchmesser von der Pulssequenz Typ 1 Glas
- Fig. 10:: Abhängigkeit der Kanalrundheit von der Pulssequenz Typ 1 Glas
- Fig. 11:: Abhängigkeit der Kanaldurchmesser von der Pulssequenz Typ 2 Glas
- Fig. 12:: Abhängigkeit der Kanalrundheit von der Pulssequenz Typ 2 Glas
- Fig. 13:: Abhängigkeit der Kanaldurchmesser von der Einzelpulsdauer Typ 1 Glas
- Fig. 14:: Abhängigkeit der Kanalrundheit von der Einzelpulsdauer Typ 1 Glas
- Fig. 15:: Abhängigkeit der Kanaldurchmesser von der Einzelpulsdauer Typ 1 Glas
- Fig. 16:: Abhängigkeit der Kanalrundheit von der Einzelpulsdauer Typ 1 Glas
- Fig. 17:: Abhängigkeit der Kanaldurchmesser von der Einzelpulsdauer Typ 2 Glas
- Fig. 18:: Abhängigkeit der Kanalrundheit von der Einzelpulsdauer Typ 2 Glas
- Fig. 19:: Abhängigkeit Taper-Eigenschaften von der Pulssequenz Typ 1 Glas
- Fig. 20:: Abhängigkeit Taper-Eigenschaften von der Pulssequenz Typ 2 Glas
- Fig. 21:: Fotografische Aufnahme eines Durchgangskanals mit Einprägungen
- Fig. 22a:: Schematischer Querschnitt einer Anwendung
- Fig. 22b:: Schematische Aufsicht auf eine Anwendung

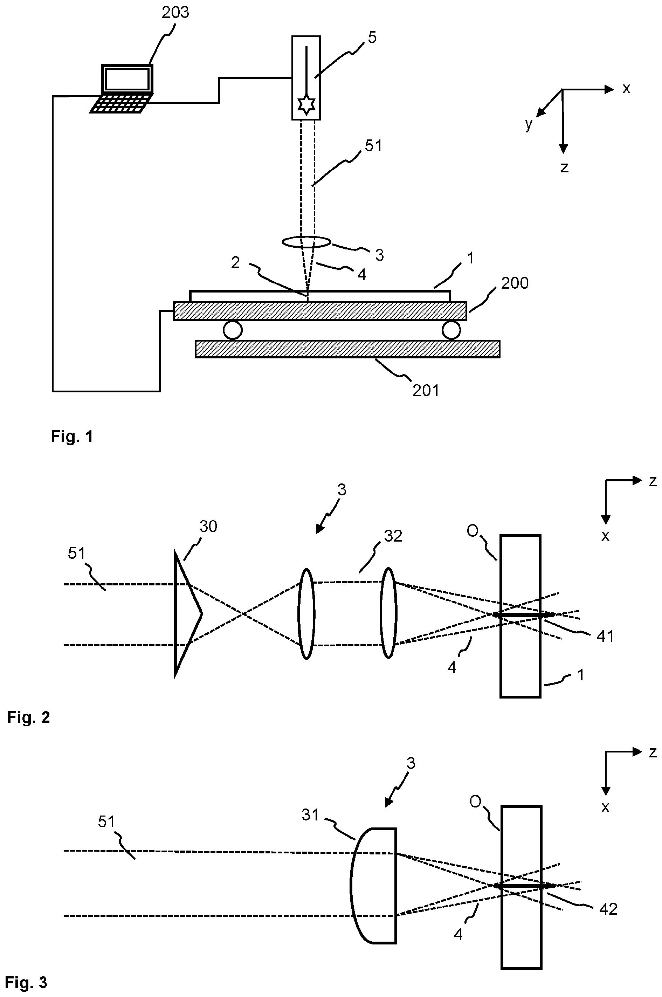

Figur 1 zeigt schematisch eine Laserbearbeitungseinrichtung, mit welcher die hierin beschriebenen Elemente 1 aus glasbasiertem Material erzeugt werden können. Insbesondere ist die Vorrichtung zur Anwendung des beschriebenen Verfahrens geeignet. Mit der Vorrichtung werden die filamentförmigen Schädigungen 2 in das Element eingebracht. Die Vorrichtung umfasst einen Ultrakurzpulslaser 5 mit einem optischen System 3. Dieses fokussiert den Laserstrahl 51 mit der Wellenlänge λ auf und/oder in das Element 1. Die Laserstrahlrichtung wird üblicherweise als z-Richtung bezeichnet. Das optische System 3 ist insbesondere so ausgebildet, dass es eine langgestreckte Fokuslinie, auch elongierter Linienfokus genannt, erzeugt. Wie beschrieben kann es ausgebildet sein, um Bessel- oder Gauss-Strahlen 41, 42 zu bilden.

Das zu bearbeitende Element 1 ist in diesem Beispiel auf einem Werkstückhalter 200 angeordnet. Mit der Positioniereinrichtung 201 kann der Auftreffpunkt des fokussierten Laserstrahls 4 des Ultrakurzpulslasers 5 auf der Oberfläche des Elements 1 positioniert werden. Die Laserstrahlrichtung wird im Allgemeinen als z-Richtung bezeichnet. Die Positioniereinrichtung 201 verfährt das Element 1 üblicherweise in x- und/oder y-Richtung, um filamentförmige Schädigungen 2 an verschiedenen Stellen des Elements 1 zu erzeugen. Ebenso möglich sind Bewegungen in z-Richtung, beispielsweise um die Fokuslage F₀ zu korrigieren und/oder einzustellen, und/oder Kombinationen der Bewegungen in alle Richtungen. Ebenso kann es vorgesehen sein, dass das optische System 3 bewegbar ist. Insbesondere können auch Bewegungen der dem Element 1 zugeordneten Positioniereinrichtung 201 und die Bewegung des optischen Systems 3 und/oder des Lasers 5 miteinander kombiniert und/oder abgestimmt werden. Dies, und optional auch Steuerungsaspekte des Lasers 5 wie Einzelpulsauslösung, Pulsdauer Tp und/oder Pulsenergie Ep können mit den vorgenannten Bewegungen kombiniert und/oder koordiniert werden. Dazu kann eine dargestellte Vorrichtung über Mikrocontroller verfügen, welche mit Datenverarbeitungseinrichtungen 203 gekoppelt sein können.

Wie beschrieben ist das Element 1 aus glasbasiertem Material ein Element, das insbesondere Glas und/oder Glaskeramik umfasst. Die Wellenlänge λ des Lasers 5 wird wie bereits beschrieben so ausgewählt, dass das Element transparent für diese Wellenlänge ist.

Fig. 2 zeigt ein optisches System, welches einem Besselstrahl 41 erzeugt. Der ankommende Laserstrahl 51 hat einen Durchmesser, gemessen im Bereich der Energie von 1/e², von üblicherweise einigen Millimetern. Ein asphärisches optisches Element 30, hier ein Axicon, dessen Apex auf das Element 1 ausgerichtet ist, bildet einen Besselfokus 41 in Form eines verlängerten Linienfokus, der mit Hilfe einer Teleskop-Linsenanordung 32 in dem zu bearbeitenden Element 1 abgebildet wird. Die Teleskop-Linsenanordnung 32 ist optional. Entsprechende optische Systeme 3 und Aufbauten sind bekannt und in der Einleitung erwähnt.

Fig. 3 stellt ein optisches System dar, welches einen Gaussstrahl 42 erzeugt. Jede Linse erzeugt eine Strahltaille und darin eine Fokuslinie. Die chromatische und/oder sphärische Aberration einer Linse 31 kann allerdings genutzt werden, um die Fokuslinie weiter zu verlängern. Dabei erzeugt der ankommende Laserstrahl 51 im Element einen elongierten Linienfokus und/oder synonym eine Fokuslinie, hier eine Gauss-Fokuslinie 42. Auch solche optischen Systeme 3 sind bekannt und in der Einleitung gewürdigt.

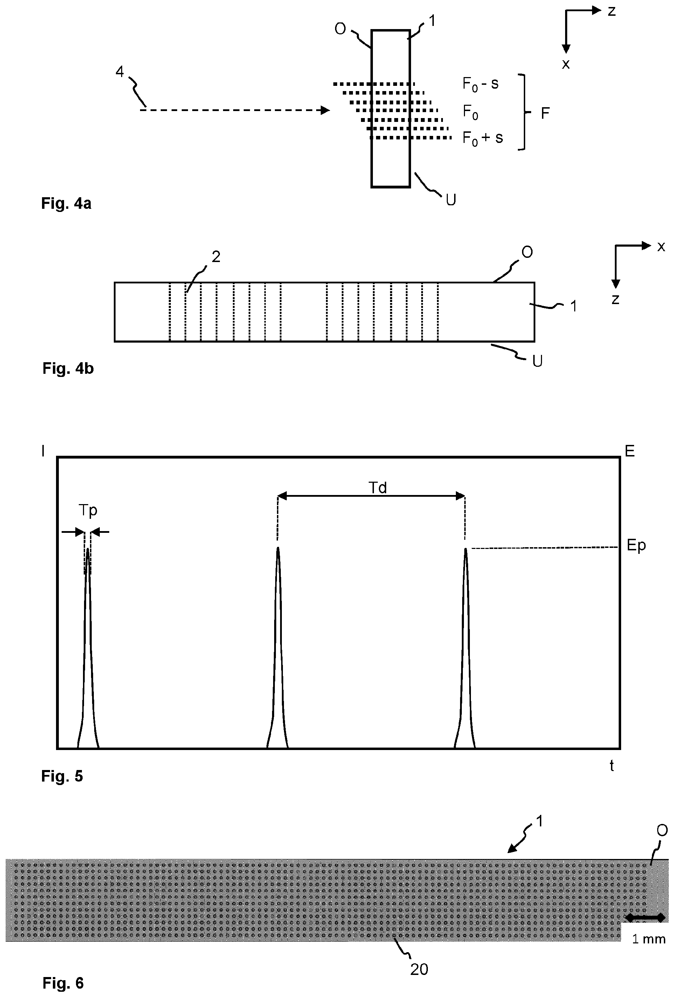

Fig. 4a verdeutlicht verschiedene Fokuslagen F im Bereich F₀ ± s im Element 1. Fokuslage F bedeutet im Sinne der Beschreibung die reale Lage des Fokus, insbesondere des Linienfokus, bzgl. der Tiefe im Element 1. Oder mit anderen Worten die Fokuslage in Laserstrahl- oder z-Richtung. Ausgehend von einer initial eingestellten Fokuslage F₀ kann die Lage in z-Richtung variiert werden, beispielsweise durch Schwankung der z-Lage insbesondere beim schnellen Bearbeiten und/oder Verfahren des Elements 1 relativ zum Laser 5, insbesondere unter Produktionsbedingungen, oder um bestimmte Ausbildungen der filamentförmigen Schädigungen 2 einzustellen. Wie voran beschrieben haben die Erfinder erkannt, dass der Fokuslagenbereich F₀ ± s relevant für ein stabiles Prozessfenster ist, in dem die Durchmesservarianz und/oder die Rundheitsvarianz gering sind. Das stabile Prozessfenster liegt innerhalb des Bereichs F₀ ± s. Dieser kann insbesondere ein bis einige Millimeter betragen. Für die Beurteilung der Fokuslagentoleranz in einem stabilen Prozessfenster wird somit als Zahlenwert der Breite des Fokuslagenbereichs F₀ ± s herangezogen. Mit anderen Worten kann die reale Fokuslage unter Produktionsbedingungen innerhalb des Fokuslagenbereichs variieren, und trotzde, werden die Qualitätsanforderungen erfüllt.

Fig. 4b zeigt die im Element 1 erzeugten filamentförmigen Schädigungen 2, die sich von der Oberseite O bis zur Unterseite U des Elements 1 erstrecken.

Fig. 5 stellt eine Folge von Einzelpulsen in dem Zeitintervall t dar. Jeder Einzelpuls hat die Pulsbreite Tp gemessen wie beschrieben, eine Pulsenergie Ep und erzeugt im Sinne der Erfindung jeweils eine filamentförmige Schädigung 2, welche in folgenden Verfahrensschritten zu Durchgangskanälen 20 aufgeätzt wird. Die Einzelpulse erfolgen hintereinander im Zeitintervall Td. Die Energie des Einzelpulses Ep entspricht dem Integral der Intensität des Pulses über der Zeit t. Wie beschrieben eignen sich insbesondere Pulsbreiten Tp von 0,3 ps bis <5 ps, vorteilhaft von 0,5 ps bis 4 ps, besonders vorteilhaft von 0,8 ps bis 3 ps zum Erreichen von stabilen Prozessfenstern. Die Einzelpulsenergie Ep beträgt dabei insbesondere vorteilhaft von 300 µJ bis 600 µJ.

Die Pulsrate wird mit der Verfahrgeschwindigkeit der Positioniereinrichtung abgestimmt, Die Kombination von Verfahrgeschwindigkeit der Positioniereinrichtung V_Pos und zeitlichem Einzelpulsabstand Td bestimmt den Pitch, also den Abstand, zwischen den filamentförmigen Schädigungen 2.

Fig 6. Zeigt die fotografische Aufnahme der Aufsicht eines Abschnitts eines wie beschrieben erzeugten Elements 1 mit Durchgangskanälen 20, also nach dem Ätzen, in einer Durchlichtaufnahme. Die Durchgangskanäle 20 sind als dunkle kreisförmige Strukturen deutlich erkennbar. Der Maßstab ist ebenfalls abgebildet, hier 1 mm. Wie ebenfalls zu erkennen ist, liegen innerhalb einer Fläche von 1x1 mm eine Vielzahl von Durchgangskanälen 20 vor, die wie zuvor beschrieben untersucht wurden.

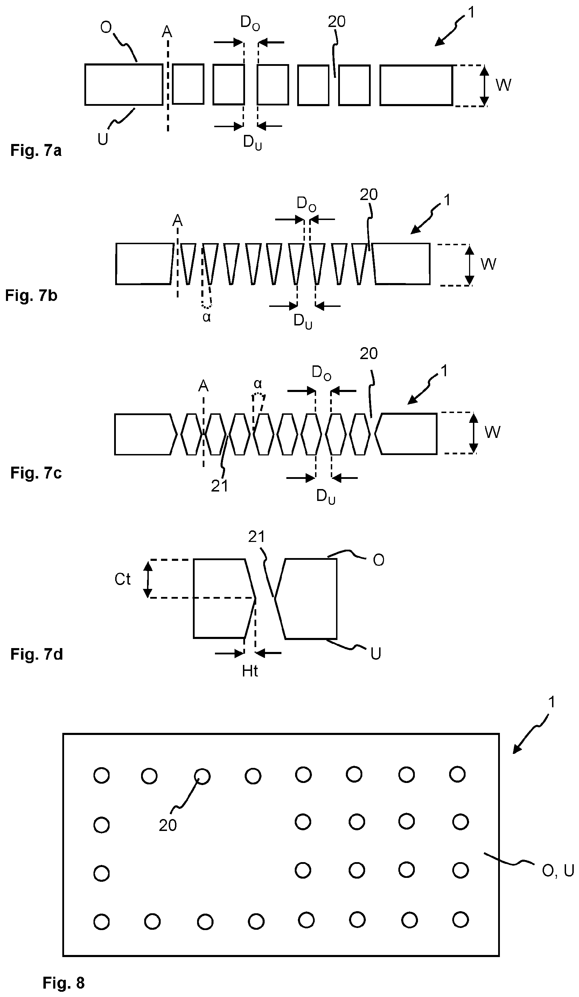

In den Fig. 7a bis 7d sind schematisch die Querschnitte durch filamentierte und danach aufgeätzte Elemente 1 aus glasbasiertem Material dargestellt, um schematisch mögliche Formen von Durchgangskanälen 20 zu verdeutlichen. Der Querschnitt erfolgt in einer Ebene senkrecht durch die Oberfläche der Oberseite O und durch die Kanalachse A hindurch. Fig. 7a zeigt den einfachsten Fall, wenn zylinderförmige Durchganskanäle 20 in das Element 1 eingebracht werden. Die Filamentachse A geht durch den Mittelpunkt des Durchgangskanals 20, auch Kanal genannt. Die Kanalwände sind achssymmetrisch und/oder zylinderförmig. Im dargestellten Beispiel verbinden die Kanäle Oberseite O des Elements 1 mit dessen Unterseite U. Die Oberseite O ist die dem Laserstrahl zugewandte Seite, die Unterseite U die gegenüberliegende Seite. Das Element 1 kann insbesondere scheibenförmig sein. Die Fläche der Ober- und Unterseite O, U sind hier sehr viel größer als die Flächen der Seitenwände.

Entsprechend Fig. 7b, die einen Schnitt wie Fig. 7a zeigt, kann auch ein kegelstumpfförmiger oder V-förmiger Durchgangskanal 20 erzeugt werden. Ein Solcher ist insbesondere auch achsensymmetrisch zur Kanalachse A. In der vorliegenden Darstellung öffnet sich der Kanal zur Unterseite U des Elements hin. Das bedeutet, dass der Durchmesser D_{O} des Kanals an der Oberseite O des Elements 1 kleiner ist als der Durchmesser D_{U} an der Unterseite U. Die Aufweitung des Kanals in Richtung einer Seite des Elements 1 kann insbesondere durch das Einstellen der Fokuslage F um F₀ und/oder der Ausbildung des optischen Systems 3 eingestellt werden, insbesondere durch Einstellen der Konvergenz des Laserstrahls 4 und den Abstand zum Element 1.

Übliche Kanalwinkel α bei V- oder X-förmigen Durchgangskanälen 20 betragen von 0,1° bis etwa 30°, insbesondere von 0,1° bis 10° oder von 0,2° bis 3°. Dieser Kanalwinkel α wird gemessen zwischen der Senkrechten durch das Element und der inneren Wandung des Durchganskanals 20 und entspricht damit dem halben Öffnungswinkel.

In Fig. 7c sind sanduhrförmige oder synonym X-förmige Durchgangskanäle 20 dargestellt. Diese Ausführungsform lässt sich insbesondere dadurch erzeugen, dass der Bereich der engsten Fokussierung des Laserstrahls 51 in das Volumen des Elements 1 gelegt wird. Für die Kanalwinkel α und damit die Öffnungswinkel 2·α sind die gleichen Bereiche vorteilhaft wie für die V-förmigen Kanäle 20 genannt. Die V-förmigen Kanäle 20 zeichnen sich durch eine Einschnürung des Kanaldurchmessers in einem Bereich entlang der Kanalachse A aus. In dem dargestellten Beispiel liegt die Einschnürung in der Mitte des Elements 1, d.h. in gleichem Abstand zu dessen Oberflächen. Es gibt ebenso Ausführungsformen, bei denen die Einschnürung näher an einer Oberfläche des Elements angeordnet ist als an der Gegenüberliegenden.

Fig. 7d zeigt einen Ausschnitt auf Fig. 7c. Es wird das Detail einer X-förmigen Durchgangskanals 20 mit der Einschnürung 21 gezeiht. Um einen solchen Durchgangskanal zu beschreiben, kann die Lage der Einschnürung, genannt Taper-Center Ct, gemessen werden. Ct gibt die Lager der Einschnürung in der Tiefe oder Dicke W des Elements 1 an. Angestrebt wird üblicherweise ein symmetrisches X, wobei die Einschnürung 21 auf halber Strecke des Durchgangskanals liegen soll, also bei ½ W. Der Winkel des Tapers kann über die Taper-Height Ht bestimmt werden, also sozusagen wie weit die Einschnürung 21 über die zylindrische Einhüllende des Durchgangskanals heraussteht.

Fig. 8 zeigt die schematische Aufsicht auf ein Element 1 aus glasbasiertem Material, in welches filamentförmige Schädigungen 2 in einer vorbestimmten Matrix mittels den beschriebenen Laserprozessen eingebracht und anschließend zu Durchgangskanälen 20 aufgeätzt wurden.

Das Element 1 entspricht hier im Wesentlichen einer Scheibe und/oder dem Ausschnitt eines in der Regel runden Wafers, in dem eine Vielzahl von Durchgangskanälen 20 an vorgegebenen Positionen eingebracht sind. Zur Erzeugung wird wie beschrieben das Element 1 relativ zum Laser 5 verfahren und dort mittels Laserpuls die filamentförmige Schädigung 2 eingebracht, welche als Initialschädigung der Vorläufer des Durchgangskanals 20 ist, der durch nachfolgende Ätzverfahren aus der filamentförmigen Schädigung 2 resultiert.

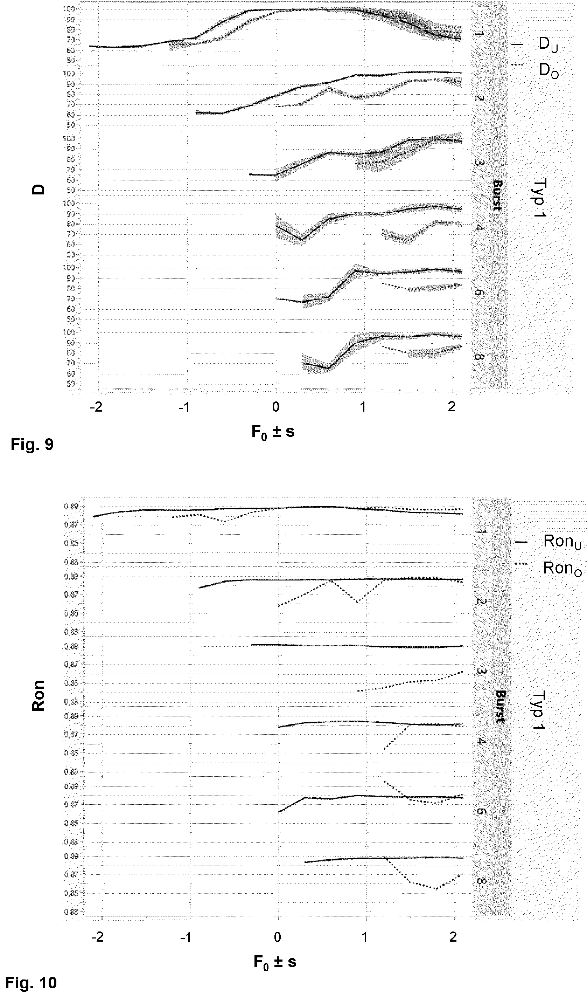

Die Fig. 9 bis 18 sind prinzipiell wie folgt zu interpretieren: Es werden die Abhängigkeit der Mittelwerte der Durchmesser D_{O}, D_{U} oder der Mittelwerte der Rundheit Ron_{O}, Ron_{U}, der Durchganskanäle 20 an den Kanaleingängen und -ausgängen auf der Oberseite O und Unterseite U des Elements 1 abhängig von der realen Fokuslage F im Fokuslagenbereich F₀ ± s gezeigt. Auf der Abszisse sind die Fokuslagen F₀ ± s angegeben, und auf der Ordinate die Mittelwerte für die Durchmesser D_{O}, D_{U} der Kanaleingänge und -ausgänge auf der Oberseite O und der Unterseite U in Micometern oder die Mittelwerte der Rundheit Ron_{O}, Ron_{U}. Dies erfolgt in jeder Fig. bei einer Variation von Laserparametern, wie Pulsdauer Tp, Einzelpuls oder Burstsequenz, oder Pulsenergie Ep, und für glasbasierte Materialien des Typs 1 und des Typs 2. Ein gutes anzustrebendes Ergebnis und ein Erfüllen der angestrebten Qualitätsmerkmale liegt dann vor, wenn die Durchmesser der Kanaleingänge und -ausgänge auf der Ober- und Unterseite D_{O}, D_{U} (genauer gesagt deren Mittelwert) über einen möglichst weiten Bereich von F₀ ± s möglichst identisch oder nahe beieinander sind, dort also sozusagen auf einer waagerechten Linie liegen, und damit Diff_{D} und/oder Var_{D} in diesem Bereich möglichst gering sind. Gleiches gilt für die Rundheit, d.h. es wird angestrebt, dass die Rundheit der Kanaleingänge (genauer gesagt deren Mittelwerte) auf der Ober- und Unterseite Ron_{O}, Ron_{U} über einen möglichst weiten Bereich von F₀ ± s möglichst identisch oder nahe beieinander sind, mithin Var_{R} möglichst gering ist. Ein stabiles Prozessfenster liegt insbesondere dann vor, wenn gleichzeitig Diff_{D} und/oder Var_{D} und Var_{R} über einen möglichst weiten Bereich von F₀ gering sind und dieser Bereich sowohl für die Durchmesser-Qualitätsmerkmale als auch die Rundheits-Qualitätsmerkmale identisch ist.

Der Fokuslagenbereich F₀ ± s wird in der Einheit mm angegebe, wobei die Lage von 0 rein willkürlich ist. Es kommt auf sie Breite von F₀ ± s an.

Fig. 9 zeigt die Abhängigkeit der Mittelwerte der Durchmesser D der Kanalmündungen D_{O}, D_{U} auf der Oberseite und Unterseite eines Elements 1 aus einem Glas des Typ 1 abhängig von der Fokuslage F₀ ± s und der Pulsfolge als Einzelpuls oder Burstsequenz. "Burst" gibt die Zahl der Pulse im Burstpaket an. Burst 1 ist also ein Einzelpuls, Burst 2 ein Burst von 2 Pulsen usw.. Es wird angestrebt, dass die Durchmesservarianz Var_{D} in einem Bereich von F₀ ± s möglichst gering ist, was wie beschrieben bedeutet, dass die Mittelwerte der Durchmesser der Kanaleingänge auf der Oberseite- und Unterseite in einem Bereich von F₀ ± s weitestgehend übereinander liegen sollen.

Für die Definition der Durchmesservarianz Var_{D} und die Ermittlung der Durchmesser wird auf die in der Beschreibung genannten Definitionen verwiesen. Insbesondere wird darauf hingewiesen, dass dementsprechend als Durchmesser die mittleren Durchmesser der Testmenge dargestellt sind.

Das oberste Linienpaar in Fig. 9 zeigt die Mittelwerte der Durchmesser der Kanalmündungen D_{O} auf der Oberseite des Elements und D_{U} auf der Unterseite, bei denen die filamentförmige Schädigung 2 durch einen Einzelpuls (Burst 1) erzeugt wurde. Die folgenden Linienpaare zeigen die entsprechenden Ergebnisse mit einem 2-fach Burst (Burst 2), 3-fach Burst (Burst 3) usw. bis 8-fach Burst (Burst 8). Die filamentförmigen Schädigungen 2 wurden nachfolgend zu Durchgangskanälen 20 mit den in der Fig. angegebenen Durchmessern D_{O}, D_{U} aufgeätzt (genauer gesagt den Mittelwerten von D_{O} und D_{U}). Die Kurven für D_{O} und D_{U} liegen nur bei dem Einzelpuls übereinander, und zwar in einem Bereich von F₀ ± s von etwa 0,2 bis 1 mm. In einem Fokuslagenbereich von 0,8 mm ist also mit einem Einzelpuls eine geringe Diff_{D} und Var_{D} zu erreichen.

Die grau schattierten Bereiche um die Kurven sind die statistischen Fehlerbalken, die exemplarisch in der Fig. 9 gezeigt werden.

Schon bei der Anwendung eines 2-er Bursts sind nur bei zwei singulären Fokuslagen F₀ Schnittpunkte von Dₒ und D_{U} und damit eine geringe Durchmesserdifferenz Diff_{D} vorhanden. Ein stabiles Prozessfenster ist im 2-fach Burst nicht erreichbar.

Bei einem 3-fach Burst wird nur ein einziger Schnittpunkt der Kurven für Dₒ und D_{U} erreicht. Bei den übrigen untersuchen 4-, 6- und 8-fach Burst sind wiederum keine Bereiche für die Fokuslage erkennbar, in denen die Durchmesserkurven aufeinander liegen.

Fig. 10 zeigt in einer analogen Darstellung zu Fig. 9 die Abhängigkeit der Mittelwerte der Rundheit Ron_{O}, Ron_{U} der Kanaleingänge auf der Oberseite und Unterseite in Abhängigkeit der Fokuslage F₀ und deren Verhalten bzgl. des Einsatzes eines Einzelpuls oder einer Burstsequenz bei einem Element aus einem Typ 1 Glas. Wie im Vergleich zu Fig. 9 ersichtlich ist, scheint die Rundheit etwas weniger empfindlich auf den Einsatz des Bursts zu reagieren. Nichtsdestotrotz zeigt sich auch hier, dass ein stabileres Prozessfenster nur bei einem Einzelpuls bereitgestellt wird.

Wie zuvor beschrieben müssen sowohl Diff_{D} und/oder Var_{D} als auch die Varianz der Rundheit Var_{R} bei der Beurteilung eines stabilen Prozessfensters herangezogen werden. Die Gesamtbetrachtung der in Fig. 9 und Fig. 10 dargestellten Ergebnisse belegt, dass der Einzelpuls die Grundlage für die Bereitstellung eines stabilen Prozessfensters ist, insbesondere bei einem Element 1 aus einem Typ 1 Glas, nicht aber der Einsatz einer Burstsequenz.

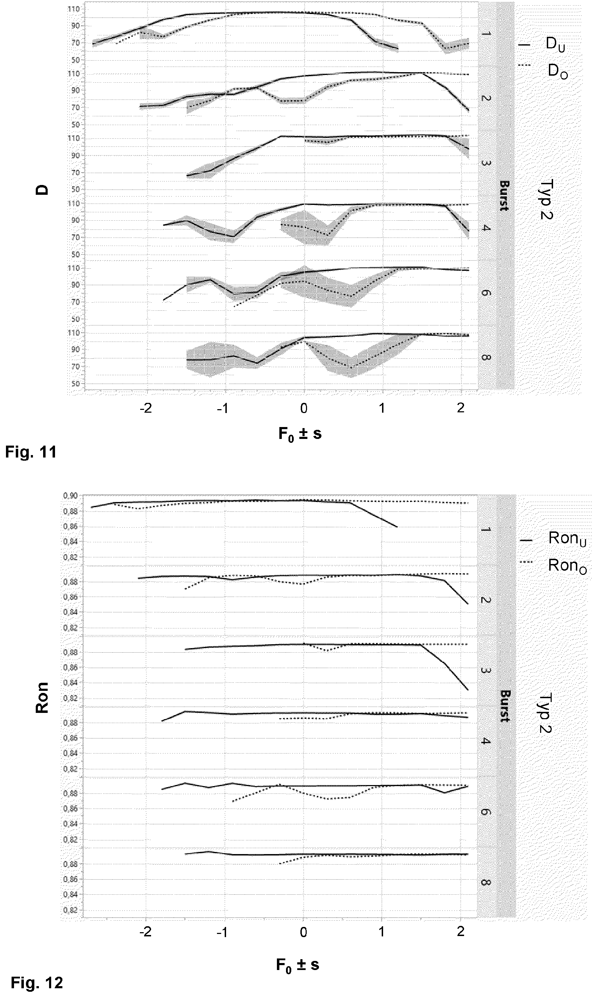

Fig. 11 stellt die Abhängigkeit der Mittelwerte der Durchmesser D_{O}, D_{U} in Abhängigkeit der Fokuslage F₀ ± s analog zu Fig. 9 für ein Element 1 aus einem Typ 2 Glas dar. Im Vergleich zu Fig. 9 fällt auf, dass ein Typ 2 Glas offensichtlich weniger empfindlich auf die Anwendung einer Burstsequenz reagiert. Sowohl bei einem 3-fach Burst als auch bei einem 4-fach und 6-fach Burst liegen die Kurven für D_{O} und D_{U} in Bereichen von F₀ ± s übereinander, allerdings ist der Bereich bei einem Einzelpuls am breitesten, hier in einem Bereich von etwa -0,8 bis 0,2 mm, mithin in einem Fokuslagenbereich von etwa 1 mm.

Fig. 12 zeit die Abhängigkeit der Rundheit von der Fokuslage analog zu Fig. 10 für verschiedene Pulssequenzen, hier wiederum für eine Element 1 aus einem Typ 2 Glas. Auch hier ist die geringere Empfindlichkeit des Typ 2 Glases bemerkenswert. In der Zusammenschau mit der Betrachtung der Durchmesserdifferenzen entsprechend Fig. 11 ist allerdings auch hier klar festzustellen, dass der breiteste Fokuslagenbereich, der für die Durchmesserbetrachtung als auch für die Rundheitsbetrachtung übereinander liegen muss, bei einem Einzelpuls erreichbar ist.

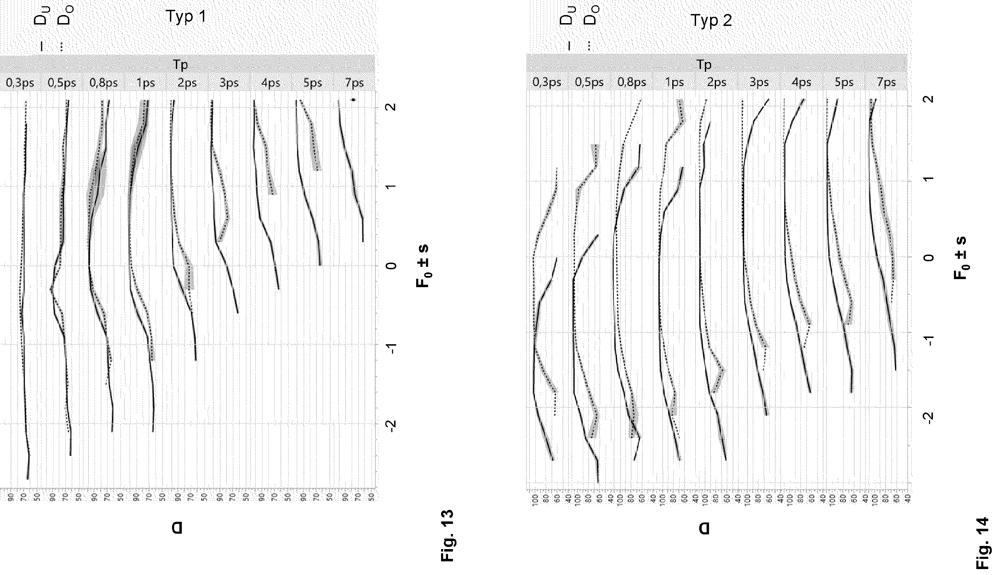

Fig. 13 und stellt die Abhängigkeit der Durchmesser D_{O} und D_{U} von der Fokuslage für verschiedene Pulsdauern Tp des Einzelpulses dar, in Fig. 13 für Elemente 1 aus einem Typ 1 Glas und in Fig. 14 aus einem Typ 2 Glas.

Wie ersichtlich ist, liegen die Kurven bei Tp-Werten von 0,3 ps bis 2 ps für ein Typ 1 Glas in breiteren Bereichen von F₀ ± s übereinander und für ein Typ 2 Glas in einem Bereich von 0,5 ps bis 4 ps. Die belegt die zuvor genannten vorteilhaften Bereiche der Einzelpulsenergien. Der beste Bereich, insbesondere zum Behandeln von beiden Glastypen, scheint ab 0,8 ps bis 3 ps oder 2 ps vorzuliegen.

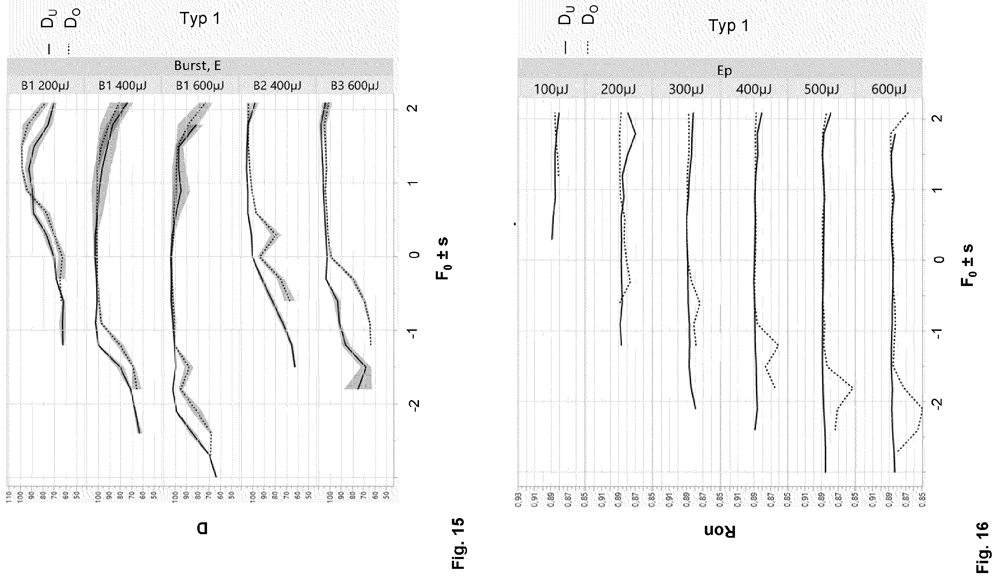

Fig. 15 und Fig. 16 veranschaulichen die Abhängigkeit der Durchmesser bzw. der Rundheit vom Fokuslagenbereich F₀ ± s für ein Element 1 aus einem Typ 1 Glas für verschiedene Energien des Laserpulspakets, sowohl für Einzelpulse als auch für Burstpakete. In den Fig. bedeutet B1 einen Einzelpuls, B2 ein Burstpaket mit 2 Pulsen und B3 ein Burstpaket mit 3 Pulsen. Die Angabe der Laserenergie in den Burstpaketen bezieht sich die Energie in dem jeweiligen Burstpaket.

Anhand von Fig. 15 ist ersichtlich, dass die Kurven von D_{O} und D_{U} nur beim Vorliegen eines Einzelpulses übereinander liegen, und zwar hier im Bereich für Ep von 400 µJ bis 600 µJ. Der Bereich von F₀ ± s beträgt hier etwa 1,2 mm, in dem die Fokuslage variieren kann, und trotzdem gute Diff_{D} und Var_{D} Werte erreicht werden.

Bei einer Energie von 200 µJ ist kein stabiles Prozessfenster zu erreichen. Es wird vermutet, dass die Energie für das Erzeugen einer durchgängigen filamentförmigen Schädigung nicht ausreicht. Liegt ein Burstpaket mit mehr als einem Einzelpuls vor, liegen die Kurven von D_{O} und D_{U} überraschenderweise nicht übereinander.

Fig. 16 stellt die Rundheit der Durchgangskanäle in Abhängigkeit des Fokuslagenbereichs F₀ ± s für verschiedene Einzelpulsenergien Ep dar. Hier wurde auf den Vergleich mit einem Burstpaket verzichtet, es handelt sich immer um die Darstellungen für Einzelpulse. Im Bereich von Ep von etwa 300 µJ bis 600 µJ liegen die Kurven für einen signifikanten Bereich F₀ ± s übereinander, mit einer Bereichsbreite von mindestens 1 mm, im Bereich von Ep von 400 µJ bis 500 µJ sogar von etwa 1,8 mm.

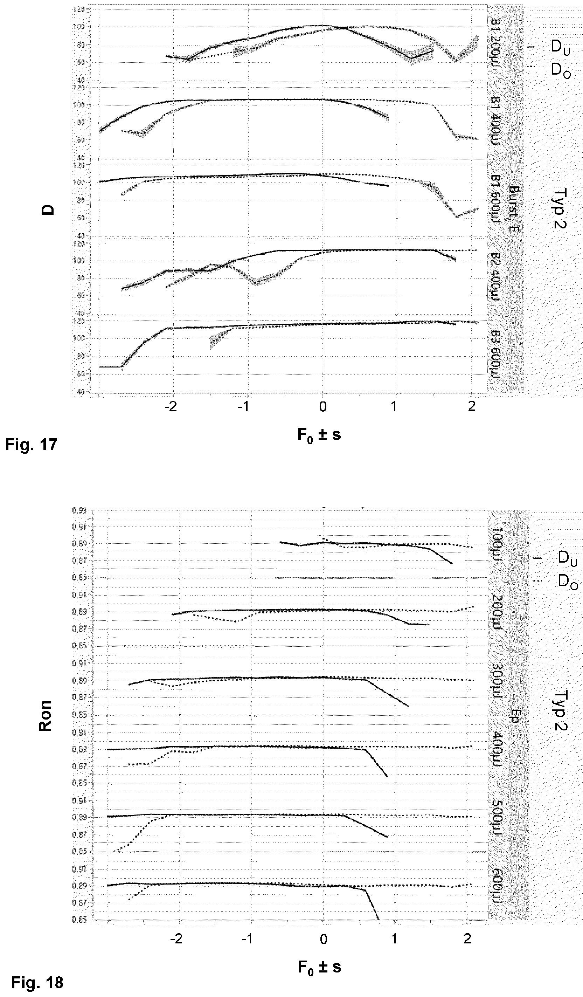

Fig. 17 und Fig. 18 sind die analogen Darstellungen zu den Fig. 15 und Fig. 16, nur für Elemente 1 aus einem Typ 2 Glas.

Anhand von Fig. 17 ist ersichtlich, dass sich die zuvor gemachte Aussage bestätigt, dass bei Einzelpulsen mit Einzelpulsenergien Ep von 400 µJ bis 600 µJ ein stabiles Prozessfenster von etwa 1,5 mm Breite erreichbar ist, ein Glas 2 Typ aber unempfindlicher ist als ein Typ 1 Glas, so dass auch mit 2-fach und 3-fach Bursts stabile Prozessfenster bzgl. der Durchmesser erreicht werden können.

Gute Rundheiten können, wie anhand Fig. 18 ersichtlich ist, mit Einzelpulsen mit einer Einzelpulsenergie Ep im Bereich von 300 µJ bis 600 µJ erreicht werden, insbesondere im Bereich von 400 µJ bis 600 µJ.

Die Erfindung stellt also ein stabiles Prozessfenster in einem Fokuslagenbereich F₀ ± s zur Verfügung, in der unabhängig vom Glastyp, insbesondere vom Glas Typ 1 oder Glas Typ 2, ein universelles stabiles Prozessfenster mit einem Einzelpuls im Energiebereich Ep von 300 µJ bis 600 µJ erreichbar ist. Insbesondere ist das Prozessfenster in einem Fokuslagenbereich F₀ ± s von etwa 1 mm bis zu 1.8 mm stabil. Werden die zuvor beschriebenen Erkenntnisse bzgl. der Pulsdauern damit kombiniert, ergibt sich ein universelles stabiles Prozessfenster für alle Glastypen.

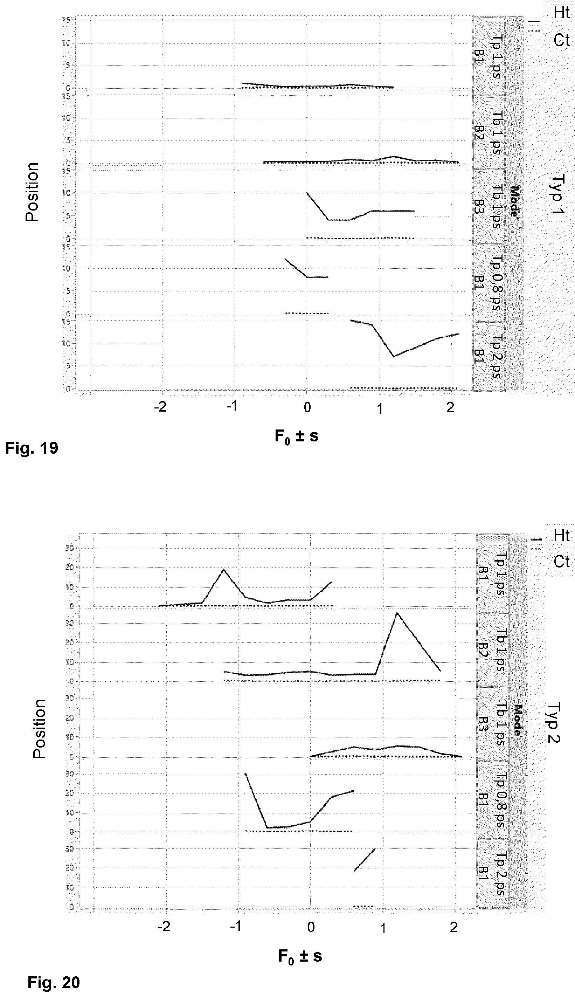

Zur Vollständigkeit zeigen Fig. 19 und Fig. 20 die Abhängigkeit der Taper-Height Ht und des Taper-Center Ct von der Fokuslage F₀ ± s für Einzelpuls oder Burstsequenzen bei unterschiedlichen Pulsdauern, hier für ein Element 1 aus einem Typ 1 Glas. Burst 1 steht wieder für einen Einzelpuls, Burst 2 für einen 2-fach Burst und Burst 3 für einen 3-fach Burst. Tp steht für die Pulsdauer des Einzelpulses. Tb die für die Dauer des Burstpakets. Es wird angestrebt, dass die Kurven für Ht und Ct wieder über einen möglichst weiten Bereich von der Fokuslage F₀ ± s übereinander liegen sollen, und zwar mit konstanten Werten, d.h. möglichst waagerechte übereinander liegende Kurven in einem Fokuslagenbereich vorliegen sollten. Wie man sieht wird das für ein Element 1 aus einem Typ 1 Glas mit einem Einzelpuls der Dauer 1 ps am besten erreicht. Ein 2-fach Burst mit der Dauer des Burstpakets von 1 ps erreicht nicht ganz so gute Werte.

Fig. 20 zeigt die gleichen Messungen analog zu Fig. 19 für ein Element 1 aus einem Typ 2 Glas. Überraschend scheint das Typ 2 Glas für die Genauigkeit der Taper-Einstellung empfindlicher zu sein als das Typ 1 Glas. Wie zuvor bemerkt ist dies was die Durchmesser- und Rundheit-Genauigkeit betrifft, umgekehrt.

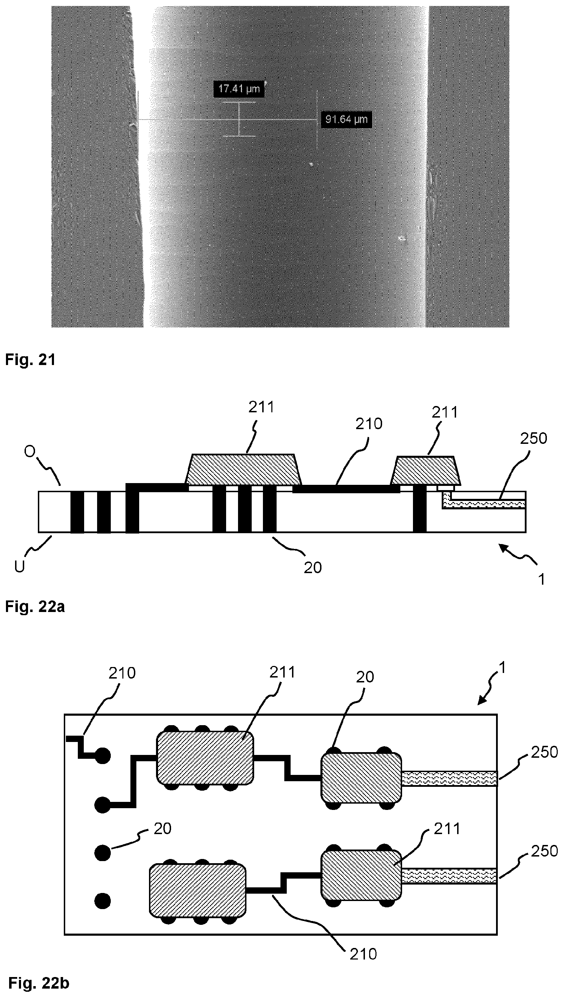

Fig. 21 gibt die fotografische Aufnahme eines Schnitts durch einen Durchgangskanal 20 eines Elements 1 wieder, das nach dem Einfügen der filamenförmigen Schädigungen durch einen Ätzprozess weiterverarbeitet wurde, wobei die filamentförmigen Schädigungen 2 zu Durchgangskanälen 20 erweitert wurden. Man erkennt deutlich die kalottenförmigen Einprägungen in der Kanalwand, die in Richtung des Umfangs der Kanalwand ausgedehnter sind als in Richtung der Kanalachse A. Ebenfalls dargestellt ist der Maßstab dieser Einprägungen. Der gesamte Durchgangskanal hat hier einen Durchmesser von 120 µm. Die kalottenförmigen Einprägungen haben eine Ausdehnung von rund 92 µm in Richtung des Umfangs der Kanalwand und von etwa 17 µm in Richtung der Kanalachse, was in etwa einem Aspektratio von 5,3 : 1 entspricht.

Fig. 22a zeigt den Querschnitt durch ein erfindungsgemäßes Element 1 als Teil einer Anwendung, wiederum rein schematisch. Der Querschnitt entspricht demjenigen der Fig. 7a bis 7c. In Anwendungen können einzelne Bauteile oder Merkmale, die in Fig. 22a gezeigt sind, natürlich auch nicht vorhanden sein und/oder es können weitere ergänzt sein. Prinzipiell zeigt Fig. 22a eine Anwendung, in welcher das erfindungsgemäße Element 1 einen Carrier-Wafer oder einen Interposer darstellt, auf dem weitere Bauteile 211, insbesondere Halbleiter-Bauteile montiert sind. Dazu sind die Durchgangskanäle 20 metallisiert, hier vollständig elektrisch leitfähig verschlossen, und auch auf einer der Hauptflächen, hier der Oberseite O, sind Metallisierungen in Form von Leiterbahnen 210 vorhanden. Die Halbleiter-Bauteile 211 können durch die Durchganskanäle 20 kontaktiert sein und/oder durch die Leiterbahnen 210 auf der Oberfläche. Ebenfalls möglich ist, dass in oder auf dem Element 1 aus glasbasiertem Material optische Wellenleiter 250 vorhanden sind. In der Fig. 22a ist ein in dem Element 1 eingebetteter Wellenleiter 250 gezeigt, der beispielsweise mittels Laserschreibens oder Ionenaustauch in das Element 1 aus glasbasiertem Material eingebracht wurde.

Fig. 22b zeigt die Aufsicht auf ein Element 1, das im Wesentlichen demjenigen der Fig. 22a entspricht.

Obwohl die vorliegende Erfindung anhand bevorzugter Ausführungsbeispiele beschrieben wurde, ist sie nicht darauf beschränkt, sondern auf vielfältige Weise modifizierbar.

Die Erfindung stellt gegenüber dem Stand der Technik den Vorteil zur Verfügung, dass das Verfahren ein universelles stabiles Prozessfenster bereitstellt, in dem ein Element 1 aus glasbasiertem Material rationell und zuverlässig mit einer Vielzahl von filamentförmigen Schädigungen 2 versehen werden kann, die in Folgeprozessen zu Durchgangskanälen 20 aufgeätzt werden können. Das Verfahren stellt unter Anwendung eines Einzelpulses ein stabiles Prozessfenster in einem breiten Fokuslagenbereich F₀ ± s zur Verfügung und ermöglicht damit die zuverlässige Erzeugung der Durchgangskanäle 20 unter Einhaltung der Konsistenz der Durchmesser D_{O}, D_{U} der Kanaleingänge und deren Rundheit. Das erfindungsgemäße Element 1 zeichnet sich dadurch aus, dass es eine Vielzahl von Durchgangskanälen 20 aufweist, welche in ihrer Gesamtheit eine sehr gute Konstanz der Durchmesser der Kanaleingänge und damit eine geringe Durchmesservarianz Var_{D} sowie eine sehr geringe Varianz der Rundheit Var_{R} aufweisen. Dies ist besonders vorteilhaft in Anwendungen im Bereich der Halbleitertechnik, wenn Halbleiter-Bauteile 211 auf Elementen 1 aus glasbasiertem Material montiert werden sollen und/oder wenn Durchganskanäle 20 metallisiert werden sollen. Die Erfindung kann damit einen Beitrag zur weiteren Miniaturisierung solcher Bauelemente leisten.

### Bezugszeichenliste

- 1: Element
- 2: filamentförmige Schädigung
- 3: optisches System
- 4: fokussierter Laserstrahl
- 5: Ultrakurzpulslaser
- 20: Durchgangskanal
- 21: Einschnürung, Taper
- 30: Axicon
- 31: aberrierende Linse
- 32: Teleskopanordnung
- 41: Bessel-Strahl
- 42: Gauss-Strahl
- 50: Laserstrahl
- 200: Werkstückhalter
- 201: Verfahreinrichtung
- 203: Microcontroller / Datenverarbeitungsanlage
- 210: Leiterbahn
- 211: Halbleiter-Bauteil
- 250: Optischer Wellenleiter

- α: Kanalwinkel
- A: Kanalachse
- D_{O}: Durchmesser Durchganskanal an der Oberseite
- D_{U}: Durchmesser Durchganskanal an der Unterseite
- E: Energie
- Ep: Einzelpulsenergie
- F₀: Fokuslage
- s: Abweichung von Fokuslage

- Ht: Taper Height
- Ct: Taper Center
- I: Intensität
- O: Oberseite
- U: Unterseite
- Rono: Rundheit Durchgangskanal an der Oberseite
- Ronu: Rundheit Durchgangskanal an der Unterseite
- T: Zeit
- Td: Einzelpulsabstand
- Tp: Einzelpulsdauer
- W: Dicke

## Patentansprüche

1. Verfahren zum Einfügen einer Vielzahl von filamentförmigen Schädigungen (2) in ein Element (1) aus glasbasiertem Material, bei dem ein durch ein optisches System (3) fokussierter Laserstrahl (4) eines gepulsten Lasers (5) mit einer Wellenlänge λ zum Bearbeiten auf das Element (1) gerichtet wird,
wobei das Element (1) im Wesentlichen transparent für die Wellenlänge λ des Lasers (5) ist,
wobei ein Einzelpuls des Lasers (5) auf das Element (1) gerichtet wird,
wobei der Einzelpuls bevorzugt eine Pulsdauer Tp von 0,3 ps bis <5 ps aufweist, besonders bevorzugt von 0,5 ps bis 4 ps, insbesondere bevorzugt von 0,8 ps bis 3 ps, ganz besonders bevorzugt von 0,9 ps bis 1,1 ps,
wobei der Einzelpuls im Element (1) eine filamentförmige Schädigung (2) erzeugt und
wobei der fokussierte Laserstrahl (4) auf verschiedene Stellen des Elements (1) gerichtet wird, um dort die filamentförmigen Schädigungen (2) zu erzeugen.

2. Verfahren nach zumindest einem der voranstehenden Ansprüche, wobei der Einzelpuls eine Einzelpulsenergie Ep von 200 µJ bis 800 µJ aufweist, bevorzugt von 300 bis 700 µJ, besonders bevorzugt von 300 µJ bis 600 µJ.

3. Verfahren nach zumindest einem der voranstehenden Ansprüche, wobei das glasbasierte Material einen CTE von 2,5·10⁻⁶ K⁻¹ bis 10,0·10⁻⁶ K⁻¹ aufweist, bevorzugt von 2,5·10⁻⁶ K⁻¹ bis 5,5·10⁻⁶ K⁻¹ oder von >5,5·10⁻⁶ K⁻¹ bis 8,0·10⁻⁶ K⁻¹, besonders bevorzugt ist das glasbasierte Material ein Multikomponentenglas ist enthaltend (in Gew% auf Oxidbasis) SiO₂ + Al₂O₃ von 55% bis 85%.

4. Verfahren nach zumindest einem der voranstehenden Ansprüche, wobei das Element (1) aus glasbasiertem Material ein Multikomponentenglas ist enthaltend (in Gew% auf Oxidbasis):
| | |
|---|---|
| SiO₂ | 55 - 85, |
| Al₂O₃ | 0 - 20, |
| B₂O₃ | 0 - 30, |
| Alkalien | 0 - 15. |

5. Verfahren nach zumindest einem der voranstehenden Ansprüche, wobei das glasbasierte Material einen CTE von 2,5·10⁻⁶ K⁻¹ bis 5,5·10⁻⁶ K⁻¹ aufweist und enthält (in Gew% auf Oxidbasis):
| | |
|---|---|
| SiO₂ | 76 - 84, |
| Al₂O₃ | 0 - 4, |
| B₂O₃ | 8 - 15, |
| Alkalien | 0 - 5,5, |
bevorzugt mit SiO₂ + Al₂O₃ von 76 bis 85, oder
wobei das glasbasierte Material einen CTE von >5,5·10⁻⁶ K⁻¹ bis 8,0·10⁻⁶ K⁻¹ aufweist und
enthält (in Gew% auf Oxidbasis):
| | |
|---|---|
| SiO₂ | 60 - 73, |
| Al₂O₃ | 0 - 15, |
| B₂O₃ | 6 - 26, |
| Alkalien | 0,5 - 15, |
bevorzugt mit SiO₂ + Al₂O₃ von 65 bis <76.

6. Verfahren nach zumindest einem der voranstehenden Ansprüche, wobei das Element (1) aus glasbasiertem Material eine Dicke W von 0,3 mm bis 1,5 mm aufweist, insbesondere von 0,5 mm bis 1,2 mm und/oder wobei mehr als 1000, insbesondere von 1000 bis 10⁷ filamentförmige Schädigungen (2) in das Element (1) eingebracht werden.

7. Verfahren nach zumindest einem der voranstehenden Ansprüche, wobei die filamentförmigen Schädigungen (2) durch das Einwirken eines Ätzmediums zu Durchgangskanälen (20) aufgeweitet werden, bevorzugt umfasst das Ätzmedium H₂SiF₆ oder Mischungen von HF und H₂SO₄ oder HF und/oder HCl oder NaOH und/oder KOH.

8. Verfahren nach Anspruch 7, wobei der oder die Durchgangskanäle (20) einen Durchmesser (D_{O}, D_{U}) von 5 µm bis 200 µm aufweisen, bevorzugt von 10 µm bis 150 µm, besonders bevorzugt von von 20 µm bis 120 µm, ganz besonders bevorzugt von 40 µm bis 100 µm , gemessen an der Kanalmündung auf der Ober- oder der Unterseite (O, U) des Elements (1), bevorzugt.

9. Verfahren nach zumindest einem der Ansprüche 7 bis 8, wobei ein stabiles Prozessfenster bzgl. des Fokuslagenbereichs (F₀ ± s) des fokussierten Laserstrahls (2) eingestellt wird, in dem die Durchmesservarianz Var_{D} der Durchmesser (D_{O}, D_{U}) der Kanalmündungen der Durchgangskanäle (20) auf der Oberseite (O) und der Unterseite (U) des Elements (1), gemessen wie hierin beschrieben, weniger als 5% und/oder die Durchmesserdifferenz Diff_{D} weniger als 4 µm beträgt, bevorzugt weniger als weniger als 3 µm, besonders bevorzugt weniger als 2 µm, jeweils bestimmt bei einer Testmenge von 1000 Durchgangskanälen, für jede eingestellte Fokuslage F im Fokuslagenbereichs (F₀ ± s) des fokussierten Laserstrahls.

10. Verfahren nach zumindest einem der Ansprüche 10 bis 12, wobei ein stabiles Prozessfenster bzgl. des Fokuslagenbereichs (F₀ ± s) des fokussierten Laserstrahls (2) eingestellt wird, in dem die Rundheitsvarianz Var_{R} der Rundheit der Kanalmündungen der Durchgangskanäle (20) auf der Oberseite (O) und der Unterseite (U) des Elements (1), gemessen wie hierin beschrieben, weniger er als 5% beträgt, bevorzugt weniger als 3%, besonders bevorzugt weniger als 2%, bestimmt bei einer Testmenge von 1000 Durchgangskanälen, für jede eingestellte Fokuslage F im Fokuslagenbereichs (F₀ ± s) des fokussierten Laserstrahls.

11. Verfahren zumindest einem der Ansprüche 12 bis 13, wobei ein stabiles Prozessfenster innerhalb eines Fokuslagenbreich (F₀ ± s) von > 0,5 mm eingestellt wird, insbesondere von >0,5 mm bis 2 mm oder von >0,5 mm von bis 1,8 mm oder von >0,5 mm bis 1,3 mm oder von >0,5 mm bis 1,0 mm.

12. Verfahren nach zumindest einem der Ansprüche 7 bis 11, wobei der oder die Durchgangskanäle (20) einen Öffnungswinkel (2·α) von 0° bis 3° aufweisen, gemessen von der Längsachse (A) des jeweiligen Durchgangskanals (20), bevorzugt sind die Durchgangskanäle zylinderförmig oder V-förmig oder X-förmig.

13. Verfahren nach zumindest einem der Ansprüche 7 bis 12, wobei an der inneren Wandung des Durchgangskanals (20) kalottenförmige Einprägungen erzeugt werden, die in Richtung der Umfangsfläche der inneren Durchgangskanalwandung ausgedehnter sind als in Richtung der Längsachse A des Durchgangskanals, insbesondere mit einem Aspektratio von mehr als 3:1.

14. Verfahren nach zumindest einem der Ansprüche 7 bis 13, wobei der oder die Durchgangskanäle (20) in einem folgenden Verfahrensschritt metallisiert werden.

15. Element (1) aus glasbasiertem Material beinhaltend eine Vielzahl von Durchgangskanälen (20), bevorzugt mindestens 1000 Durchgangskanäle, besonders bevorzugt von 1000 bis 10⁷ Durchgangskanäle, wobei mindestens eine Testmenge von 1000 Durchgangskanälen zumindest eines der folgenden Merkmale aufweist:
- Öffnungswinkel (2·α) von 0° bis 6°,
- Var_{D} weniger als 5% und/oder Diff_{D} weniger als 4 µm, und/oder
- Var_{R} weniger als 5%.

16. Element (1) nach Anspruch 15, wobei das glasbasierte Material ein Multikomponentenglas ist, bevorzugt mit einem CTE von 2,5·10⁻⁶ K⁻¹ bis 10·10⁻⁶ K⁻¹, bevorzugt von 2,5·10⁻⁶ K⁻¹ bis 8·10⁻⁶ K⁻¹, besonders bevorzugt mit einem CTE von 2,5·10⁻⁶ K⁻¹ bis 5,5·10⁻⁶ K⁻¹ oder von >5,5·10⁻⁶ K⁻¹ bis 8,0·10⁻⁶ K⁻¹.

17. Element (1) nach Anspruch mindestens einem der Ansprüche 15 bis 16, wobei das glasbasierte Material ein Multikomponentenglas ist enthaltend (in Gew% auf Oxidbasis) SiO₂ + Al₂O₃ von 55% bis 85%, bevorzugt von 65% bis <76%.

18. Element (1) nach Anspruch mindestens einem der Ansprüche 15 bis 17, wobei das glasbasierte Material ein Multikomponentenglas ist, enthaltend (in Gew% auf Oxidbasis)
| | |
|---|---|
| SiO₂ | 55 - 85, |
| Al₂O₃ | 0 - 20, |
| B₂O₃ | 5 - 30, |
| Alkalien | 0 - 15. |

19. Element (1) nach mindestens einem der Ansprüche 17 bis 18, wobei das glasbasierte Material einen CTE von 2,5·10⁻⁶ K⁻¹ bis 5,5·10⁻⁶ K⁻¹ aufweist und enthält (in Gew% auf Oxidbasis):
| | |
|---|---|
| SiO₂ | 76 - 84, |
| Al₂O₃ | 0 - 4, |
| B₂O₃ | 8 - 15, |
| Alkalien | 0 - 5,5, |
bevorzugt mit SiO₂ + Al₂O₃ von 76 bis 85,
oder
wobei das glasbasierte Material einen CTE von >5,5·10⁻⁶ K⁻¹ bis 8,0·10⁻⁶ K⁻¹ aufweist und enthält (in Gew% auf Oxidbasis):
| | |
|---|---|
| SiO₂ | 60 - 73, |
| Al₂O₃ | 0 - 15, |
| B₂O₃ | 6 - 26, |
| Alkalien | 0,5 - 15, |
bevorzugt mit SiO₂ + Al₂O₃ von 65 bis <76.

20. Element (1) nach mindestens einem der Ansprüche 15 bis 19, wobei das Element (1) scheibenförmig ist, wobei eine Mehrzahl von Durchgangskanälen (20) bevorzugt metallisiert sind, und wobei besonders bevorzugt das Element (1) eine Dicke W von 0,3 mm bis 1,5 mm, insbesondere von 0,5 mm bis 1,2 mm aufweist.

21. Element (1) nach mindestens einem der Ansprüche 15 bis 20, wobei sich auf zumindest einer Oberfläche des Elements (1) elektrische Leiterbahnen (210) befinden, die mit Durchgangskanälen (20) verbunden sind, insbesondere mit der Metallisierung von Durchgangskanälen (20).

22. Element (1) nach mindestens einem der Ansprüche 15 bis 21 mit zumindest einem Halbleiterbauteil (211), das auf einer Oberfläche des Elements (1) angebracht ist, und/oder einem optischen Wellenleiter (250), der in dem Element (1) eingebracht ist oder auf diesem aufgebracht ist.

23. Verwendung eines Elements (1) nach zumindest einem der Ansprüche 15 bis 22 als Interposer und/oder Substrat zur Montage von elektronischen und/oder optoelektronischen Bauelementen (211), insbesondere Halbleitern, und/oder als Substrat zum Einbringen oder Montieren von optischen Wellenleitern (250).
